(19) Europäisches Patentamt
European Patent Office
Office européen des brevets

(11) EP 3 138 116 B1

(12) FASCICULE DE BREVET EUROPEEN

(45) Date de publication et mention de la délivrance du brevet:
**11.03.2020 Bulletin 2020/11**

(21) Numéro de dépôt: **15725891.4**

(22) Date de dépôt: **30.04.2015**

(51) Int Cl.:
***H01J 37/32*** *(2006.01)*

(86) Numéro de dépôt international:
**PCT/IB2015/053150**

(87) Numéro de publication internationale:
**WO 2015/166446 (05.11.2015 Gazette 2015/44)**

(54) **PROCÉDÉ ET SYSTÈME POUR CONTRÔLER DES FLUX D'IONS DANS UN PLASMA RF**

VERFAHREN UND SYSTEM ZUR STEUERUNG EINES IONENFLUSSES IN EINEM RF-PLASMA

METHOD AND SYSTEM FOR CONTROLLING ION FLUX IN AN RF PLASMA

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.05.2014 FR 1454018**

(43) Date de publication de la demande:
**08.03.2017 Bulletin 2017/10**

(73) Titulaires:
 • **Ecole Polytechnique
 91120 Palaiseau (FR)**
 • **Centre National de la Recherche Scientifique - CNRS
 75794 Paris Cedex 16 (FR)**

(72) Inventeurs:
 • **BRUNEAU, Bastien
 F-75014 Paris (FR)**
 • **JOHNSON, Erik
 F-75020 Paris (FR)**
 • **NOVIKOVA, Tatiana
 F-91140 Villebon sur Yvette (FR)**
 • **BOOTH, Jean-Paul
 F-91470 Boullay les Troux (FR)**

(74) Mandataire: **Gevers & Orès
 Immeuble le Palatin 2
 3 Cours du Triangle
 CS 80165
 92939 Paris La Défense Cedex (FR)**

(56) Documents cités:
**US-A- 6 162 709**

 • **HEIL B G ET AL: "On the possibility of making a geometrically symmetric RF-CCP discharge electrically asymmetric", JOURNAL OF PHYSICS D: APPLIED PHYSICS, INSTITUTE OF PHYSICS PUBLISHING LTD, GB, vol. 41, no. 16, 24 juillet 2008 (2008-07-24), pages 165202-165220, XP002567808, ISSN: 0022-3727, DOI: 10.1088/0022-3727/41/16/165202 cité dans la demande**

**Description**

La présente invention concerne un procédé pour contrôler des flux d'ions dans un plasma RF et un système de mise en oeuvre du procédé.

L'invention concerne plus particulièrement un procédé pour créer une asymétrie de flux ionique sur les électrodes d'un réacteur plasma radiofréquence capacitivement couplé RF-CCP (en anglais Radio frequency capacitively coupled plasma).

L'invention concerne également un procédé de traitement plasma d'un substrat utilisant le contrôle du flux ionique de l'invention.

Les plasmas sont aujourd'hui utilisés massivement dans l'industrie, notamment dans le domaine de la microélectronique et du photovoltaïque, mais également dans l'industrie textile et l'industrie du plastique.

Les procédés de traitement plasma peuvent de façon générale, être divisés entre les procédés de dépôt, les procédés de gravure, et les procédés de modification de surface d'un substrat.

L'invention peut s'appliquer à tous ces types de dépôt plasma et à toutes les industries.

Les plasmas radiofréquence capacitivement couplés sont utilisés dans une large gamme de procédés industiels comme la fabrication de semiconducteurs ou la production de larges surfaces de panneaux solaires. La décharge est mise en œuvre entre deux électrodes, une tension radiofréquence étant appliquée à une première électrode, et une deuxième électrode formant une contre-électrode étant au même potentiel que les parois de la chambre du réacteur, c'est-à-dire mise à la masse.

L'utilisation d'une chambre de réacteur plasma géométriquement asymétrique, c'est-à-dire ayant deux électrodes de surfaces différentes, permet de changer les flux d'ions sur les électrodes mais s'accompagne d'un changement d'énergie des ions. De plus, lors d'un transfert vers un réacteur industriel, cette propriété est souvent perdue, en raison de la grande taille du réacteur qui rend sa configuration géométriquement symétrique.

Afin de rémédier à cette difficulté, il est connu d'utiliser une somme cohérente de plusieurs harmoniques RF de fréquence comme source excitatrice d'un plasma.

Ainsi, l'article de de B.G. Heil, U. Czanetzki, R.P. Brinkmann, et T. Mussenbrock, intitulé « On the possibility of making a geometrically symmetric RF-CCP discharge electrically asymmetric » et publié dans Journal of Physics D : Applied Physics, vol. 41, n°.16, p.165202, August 2008, décrit l'effet d'asymétrie électrique (EAE en anglais Electrical Asymmetry Effect) résultant de l'utilisation d'une forme d'onde non-sinusoïdale comme somme cohérente de deux harmoniques RF de fréquence.

Dans la demande de brevet EP 2 249 372 A1 dont inventeurs sont les auteurs précités, un procédé pour induire électriquement une asymétrie d'amplitude entre les champs électriques des gaines des électrodes exposées à un plasma est décrite. L'énergie des ions est ajustée en établissant une tension d'autopolarisation en vis à vis de l'une des électrodes par application d'une tension RF ayant au moins deux composantes fréquentielles harmoniques avec un contrôle de la phase entre les deux composantes fréquentielles. Au moins une des composantes fréquentielles les plus élevées est un multiple pair de la composante fréquentielle la plus basse. Le procédé permet ainsi de traiter par plasma des surfaces de grande taille de substrat en ajustant l'énergie des ions au travers du réglage de la phase entre les deux composantes fréquentielles.

Dans les deux documents précités, les formes d'onde sont choisies au travers du réglage de la phase pour moduler l'énergie des ions arrivant sur une électrode mais ne sont pas choisies pour moduler les flux sur une électrode par rapport à une autre.

Il est connu également d'utiliser une forme d'onde de tension trapézoïdale pour l'excitation radiofréquence du plasma.

Dans la demande de brevet EP 2 407 998 A1, il est décrit un procédé pour exciter au moins une électrode d'un réacteur plasma capacitivement couplé contenant un substrat. L'électrode est excitée en appliquant une tension RF avec une forme d'onde trapézoïdale. La densité du plasma et les flux des espèces ioniques et neutres relativement au substrat sont controlés en ajustant la durée du front montant et/ou la durée du front descendant de la forme d'onde trapézoïdale. La fonction de distribution en énergie des ions au voisinage du substrat peut être controlée en ajustant l'amplitude et la durée relative entre le plateau supérieur et le plateau inférieur de la forme d'onde trapézoïdale.

Le document EP 2 407 998 A1 ne décrit pas la possibilité de contrôler les flux d'ions sur chaque électrode. Nulle part dans ce document n'est décrit ni suggéré un intérêt à utiliser une forme d'onde limitée de la forme d'onde trapézoïdale dans laquelle les plateaux supérieur et inférieur sont supprimés et les durées des fronts montant et descendant sont différents.

Enfin, il convient de noter qu'il a déjà été proposé d'utiliser une forme d'onde limitée de la forme d'onde trapézoïdale dans laquelle les plateaux supérieur et inférieur sont supprimées et les durées de front montant et descendant sont différents.

C'est par exemple le cas dans le document US 6 162 709.

Toutefois, dans ce document, ceci est effectué pour gérer le bombardement ionique des électrodes et pas pour générer une asymétrie de flux ionique sur ces électrodes.

Le problème technique est de proposer un procédé de contrôle de flux ionique dans un réacteur plasma RF capacitivement couplé de géométrie donnée, quelconque en termes de symétrie ou d'asymétrie, qui permette de moduler les flux ioniques sur une électrode par rapport à l'autre, ou d'un groupe d'espèces par rapport à l'autre, independamment de la puissance électrique injectée dans le plasma.

A cette fin, l'invention a pour objet un procédé de génération d'une asymétrie de flux ionique dans un réacteur plasma radiofréquence capacitivement couplé, le réacteur plasma contenant un ou plusieurs gaz mélangés sous une pression totale P, et comportant une première électrode), alimentée en énergie radiofréquence, et une deuxième électrode (26).

Le procédé comprend une étape d'excitation de la première électrode par une forme d'onde de tension radio-fréquence périodique V(t) ayant une fréquence inférieure correspondant à un harmonique fondamental de période fondamentale T de la forme d'onde, et est caractérisé en ce que :

la forme d'onde de tension normalisée en temps et en amplitude sur l'intervalle [-1 ; 1], f(u) est une forme d'onde approchée avec un degré d'approximation d'une fonction radiofréquence en dent de scie normalisée $f_{SAW}(u)$, u étant le temps normalisé défini comme le rapport du temps t sur la période fondamentale T ; et

la fonction radiofréquence en dent de scie normalisée présente un motif périodique de période fondamentale T consistant en une première portion linéaire d'évolution temporelle de la tension normalisée avec une première pente p1, suivie immédiatement d'une deuxième portion linéaire d'évolution temporelle de la tension normalisée avec une deuxième pente p2, les premiere et deuxième pentes étant d'amplitudes différentes et de signes opposés, le minimum et le maximum du motif ayant la même amplitude unitaire ; et

le degré d'approximation de la forme d'onde approchée et la pression totale P du gaz ou des gaz mélangés sont suffisamment élevés pour faire apparaître une asymétrie des flux ioniques entre le flux ionique au niveau de la première électrode et le flux ionique au niveau de la deuxième électrode.

Suivant des modes particuliers de réalisation, le procédé de génération d'une asymétrie de flux ionique comporte l'une ou plusieurs des caractéristiques suivantes, prises seules ou en combinaison :

- la plus petite valeur absolue parmi la valeur absolue de la première pente p1 et la valeur absolue de deuxième pente p2 est inférieure ou égale à une valeur égaie à 3,8 de préférence inférieure ou égale 3 ;
- la forme d'onde de tension radio-fréquence périodique V(t) est dérivable et présente une asymétrie de pente mesurée par un facteur d'asymétrie de pente F paramétré par un entier p supérieur ou égal à 1 et défini par l'équation :

$$F(p) = \left| \frac{\int_{t\in[0,T],V'>0} \left|(V'(t))^p\right| - \int_{t\in[0,T],V'<0} \left|(V'(t))^p\right|}{\int_{t\in[0,T]} \left|(V'(t))^p\right|} \right|$$

V'(t) désignant la dérivée de la forme d'onde à l'instant t, et

F(p) est supérieur ou égal à un seuil, lequel seuil dépend de l'entier p et est égal à 0,1 lorsque p est égal à 2 ;

- la pression totale P du gaz ou des gaz mélangés est supérieure ou égale à une valeur seuil de pression $P_s(gaz)$, dépendant de la nature du gaz et définie comme la pression au-dessus de laquelle une asymétrie du flux ionique apparait nettement entre le flux ionique au niveau de la première électrode et le flux ionique au niveau de la deuxième électrode, lorsque la forme d'onde normalisée est une fonction en dent de scie normalisée pour laquelle la valeur absolue de la pente la plus douce est égale à 2,5 ou le facteur d'asymétrie de pente F(2) de la forme d'onde V(t) est supérieure ou égal à 0,1 ;
- le gaz est un gaz convenant pour le dépôt de matériaux sur, pour la gravure, et pour la modification d'un substrat compris dans l'ensemble formé par l'argon, le dihydrogène, $O_2$, $Cl_2$, HBr, $CF_4$, $C_4F_8$, $CHF_3$, CO, $SiH_4$, $SiCl_4$, $SiF_4$, $CH_4$, $C_2H_6$ et les chaines carbonées de même structures, SF6, $Si_2H_6$, $SiH_xF_{4-x}$, $GeH_4$, $GeF_4$, $GeH_xF_{4-x}$, $CCl_4$, $CCl_3F$, $CCl_2F_2$, $CF_3Cl$, $C_2F_6$, $C_3F_8$, $C_5F_8$, $C_5F_{12}$, $CHF_3$, $BCl_3$ et la valeur du seuil de pression est égale à 100 mTorr lorsque le gaz est de l'argon ;
- le degré d'approximation de la forme d'onde approchée est égal à l'inverse d'une distance fonctionnelle d séparant la forme d'onde de tension approchée normalisée f(u) et la fonction radiofréquence en dent de scie normalisée $f_{saw}(u)$, la distance fonctionnelle étant comprise dans l'ensemble formé par les distances fonctionnelles $L^p$ de Lebesgue,

le degré d'approximation étant supérieur ou égal à 1,25, de préférence supérieur ou égal 2 lorsque la distance fonctionnelle d est la distance fonctionnelle $d\infty$, séparant la forme d'onde approchée normalisée et la fonction radiofréquence en dent de scie normalisée, définie par l'expression analytique :

$$d\infty(f(u); f_{SAW}(u)) = \max_{u \in [0,1]}(|f(u) - f_{SAW}(u)|$$

dans laquelle u est la variable normalisée definie par $u = \omega t/2\pi$ i ;

- la forme d'onde de tension approchée après normalisation f(u) est une forme d'onde non invariante par retournement temporel, c'est-à-dire une forme d'onde pour laquelle il n'existe pas de constante réelle $\tau$ vérifiant :
  $f(u) = f(\tau - u)$, u désignant la variable d'évolution temporelle normalisée de la forme d'onde de tension approchée normalisée ;
- pour chaque maximum courant de la forme d'onde de tension approchée normalisée identifié par un indice de parcours j, la durée séparant l'instant d'occurrence t(max(j)) du maximum courant de l'instant d'occurrence t(min(j)) du premier mimimum min(j) suivant le maximum courant max(j), est différente de la durée séparant l'instant d'occurence t(max(j+1)) du premier maximum max(j+1) succédant immédiament au premier mimimum min(j) et l'instant d'occurrence t(min(j)) du premier minimum min(j) ;
- la forme d'onde approchée avant d'être normalisée est égale à un développement d'une série tronquée approximant une fonction en dent de scie limitée à un nombre entier n des premières fréquences harmoniques, et décrite par l'équation :

$$V_{AC}(t) = V_0 \sum_{k=1}^{n} \frac{2(-1)^k}{k^2 m(1-m)\pi^2} \sin(k(1-m)\pi)\sin(k\omega t) ,$$

$V_0$ étant un facteur de tension ajusté pour obtenir une tension crête souhaitée $V_{pp}$, le nombre des premieres fréquences harmoniques n du développement de la série est étant supérieur ou égal à 2, $\omega$ étant la pulsation correspondant à la fréquence fondamentale, et m étant un paramètre réel compris entre 0 et 1, les valeurs m appartenant à l'intervalle [0,5-$\delta4$ 0,5+$\delta4$] étant excluse, $\delta4$ étant supérieur ou égal à 0,1, de préférence supérieur ou égal à 0,2 ;
- la forme d'onde approchée avant d'être normalisée est égale à un développement d'une série tronquée approximant une fonction en dent de scie limitée à un nombre entier n des premières fréquences harmoniques, et décrite suivant l'équation :

$$V_{AC}(t) = V_0 \sum_{k=1}^{n} \frac{1}{k}\cos(k\omega t + \Phi) ,$$

$V_0$ étant un facteur de tension ajusté pour obtenir une tension crête souhaitée $V_{pp}$, le nombre des premieres fréquences harmoniques n développement de la série étant supérieur ou égal à 2, $\omega$ étant la pulsation correspondant à la fréquence fondamentale,
et $\Phi$ étant une phase de décalage commune aux harmoniques comprise dans la réunion des intervalles

$$\left[\frac{\pi}{2} - \delta3, \frac{\pi}{2} + \delta3\right] \text{ et } \left[\frac{3\pi}{2} - \delta3, \frac{3\pi}{2} + \delta3\right]$$ avec $\delta3$ inférieur ou égal à $\pi/4$, de préférence inférieur ou égal à $\pi/6$, et encore plus de préférence inférieur ou égal à $\pi/8$ ;
- la forme d'onde approchée avant d'être normalisée est égale à un développement d'une série tronquée approximant une fonction en dent de scie limitée à un nombre entier n des premières fréquences harmoniques, et décrite par l'équation :

$$V_{AC}(t) = V_0 \sum_{k=1}^{n} \frac{n-k+1}{n}\cos(k\omega t + \Phi) ,$$

$V_0$ étant un facteur de tension ajusté pour obtenir une tension crête souhaitée $V_{pp}$, le nombre des premieres fréquences harmoniques n développement de la série étant supérieur ou égal à 2, $\omega$ étant la pulsation correspondant à la fréquence fondamentale,

et Φ étant une phase de décalage commune aux harmoniques comprise dans la réunion des intervalles

$$\left[\frac{\pi}{2} - \delta 2, \frac{\pi}{2} + \delta 2\right] \text{ et } \left[\frac{3\pi}{2} - \delta 2, \frac{3\pi}{2} + \delta 2\right]$$ avec $\delta 2$ inférieur ou égal à $\pi/4$, de préférence inférieur ou égal à $\pi/6$, et encore plus de préférence inférieur ou égal à $\pi/8$ ;

- la forme d'onde approchée avant normalisation égale à un développement d'une série tronquée approximant la fonction en dent de scie limitée à un nombre entier $\underline{n}$ des premières fréquences harmoniques, le nombre d'harmoniques étant supérieur ou égal 3, de préférence égal à 4 ;
- les première ét deuxième pentes p1, p2 et/ou le paramètre $\underline{m}$ sont ajustés par une boucle de rétroaction servant à obtenir la forme d'onde de tensions souhaitée à la première électrode alimentée en énergie.

L'invention a également pour objet un procédé de traitement plasma d'un substrat dans un réacteur plasma capacitivement couplé, le réacteur plasma contenant un gaz sous une pression P, et comportant une première électrode, alimentée en énergie radiofréquence, et une deuxième électrode, comprenant une étape de mise en place d'un substrat à traiter à proximité d'une électrode parmi la première électrode et la deuxièm électrode, et une étape de génération d'une asymétrie de flux ionique définie ci-dessus.

Suivant des modes particuliers de réalisation, le procédé de traitement plasma d'un substrat comporte l'une ou plusieurs des caractéristiques suivantes, prises seules ou en combinaison :

- le gaz utilisé permet de créer plusieurs espèces chimiques qui sont soit très réactives, soit peu réactives, et la forme d'onde de la tension d'excitation est ajustée de sorte, soit à rapprocher la création des espèces réactives à proximité d'une électrode lorsqu'elles sont bénéfiques au traitement du substrat, ou à éloigner les espèces sont peu réactives et agissent de manière néfaste au traitement du substrat ;
- le procédé de traitement plasma est compris dans l'ensemble formés par les procédés plasma de dépôt sur un substrat, les procédés plasma de gravure d'un substrat, et les procédés plasma de modification de la surface d'un substrat.

L'invention a également pour objet un système de traitement plasma pour créer une asymétrie du flux ionique comprenant ;

- un réacteur plasma radiofréquence capacitivement couplé, contenant un gaz ou des gaz mélangés sous une pression totale P, comportant une première électrode, alimentée en énergie radiofréquence, et une deuxième électrode, et
- un moyen de réglage de la pression totale P du gaz ou des gaz mélangés ; et
- un générateur de forme d'onde de tension, raccordé à la première électrode au travers d'une capacité de couplage, pour générer une forme d'onde de tension radio-fréquence périodique V(t) ayant une fréquence inférieure correspondant à un harmonique fondamental de la forme d'onde de période fondamentale T. ;

Le système de traitement plasma est caractérisé en ce que :

la forme d'onde de tension normalisée la forme d'onde de tension normalisée en temps et en amplitude sur l'intervalle [-1 ; 1], f(u) est une forme d'onde approchée avec un degré d'approximation d'une fonction radiofréquence en dent de scie normalisée $f_{SAW}(u)$, u étant le temps normalisé défini comme le rapport du temps t sur la période fondamentale T, et
la fonction radiofréquence en dent de scie normalisée $f_{SAW}(u)$ présente un motif périodique de période fondamentale T consistant en une première portion linéaire d'évolution temporelle de la tension normalisée avec une première pente p1, suivie immédiatement d'une deuxième portion linéaire d'évolution temporelle de la tension normalisée avec une deuxième pente p2, les premiere et deuxième pentes étant d'amplitudes différentes et de signes opposés, le minimum et le maximum du motif ayant la même amplitude unitaire ; et
le degré d'approximation de la forme d'onde approchée et la pression totale P du gaz ou des gaz mélangés sont suffisantes pour faire apparaitre une asymétrie des flux ioniques entre le flux ionique au niveau de la première électrode et le flux ionique au niveau de la deuxième électrode.

Suivant des modes particuliers de réalisation, le système comporte l'une ou plusieurs des caractéristiques suivantes, prises seules ou en combinaison :

- le moyen de réglage de la pression totale P du gaz ou des gaz mélangés et le générateur de forme d'onde de tension sont configurés pour mettre en oeuvre l'une des étapes définies ci-dessus ;
-    la deuxième électrode est mise à la masse ou à un potentiel flottant.

L'invention sera mieux comprise à la lecture de la description de plusieurs formes de réalisation qui vont suivre, données uniquement à titre d'exemples et faites en se référant aux dessins dans lesquels :

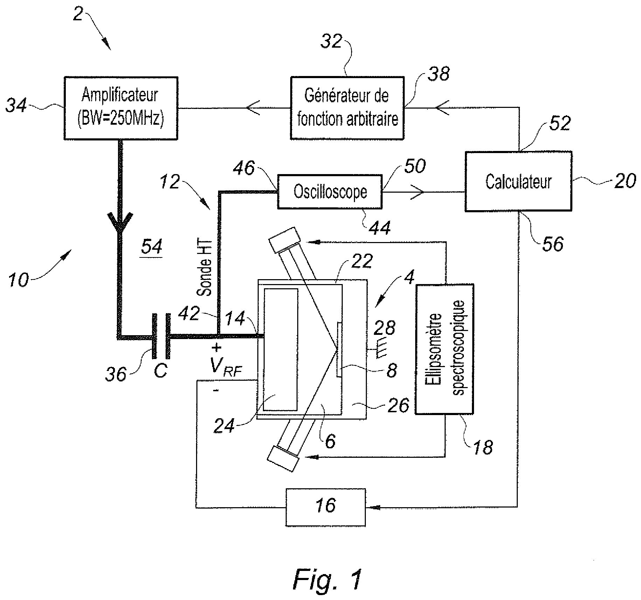

La Figure 1 est une vue schématique de l'architecture d'un système mettant en œuvre un procédé de traitement plasma selon l'invention d'un substrat à l'aide d'un réacteur plasma RF couplé capacitivement et excité par un générateur de forme d'onde à effet d'asymétrie de pente ;

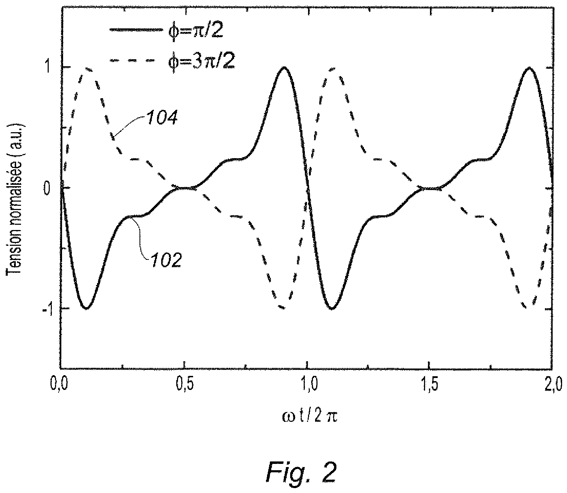

La Figure 2 est une vue d'une première forme d'onde et d'une deuxième forme d'onde de tension normalisée selon une première forme de réalisation, la tension d'excitation $V_{AC}(t)$ avant normalisation vérifiant l'équation

$$V_{AC}(t) = V_0 \sum_{k=1}^{4} \frac{5-k}{4} \cos(k\omega t + \Phi)$$

pour une valeur de $\Phi$ égale respectivement à $\pi/2$ et $3\pi/2$ ;

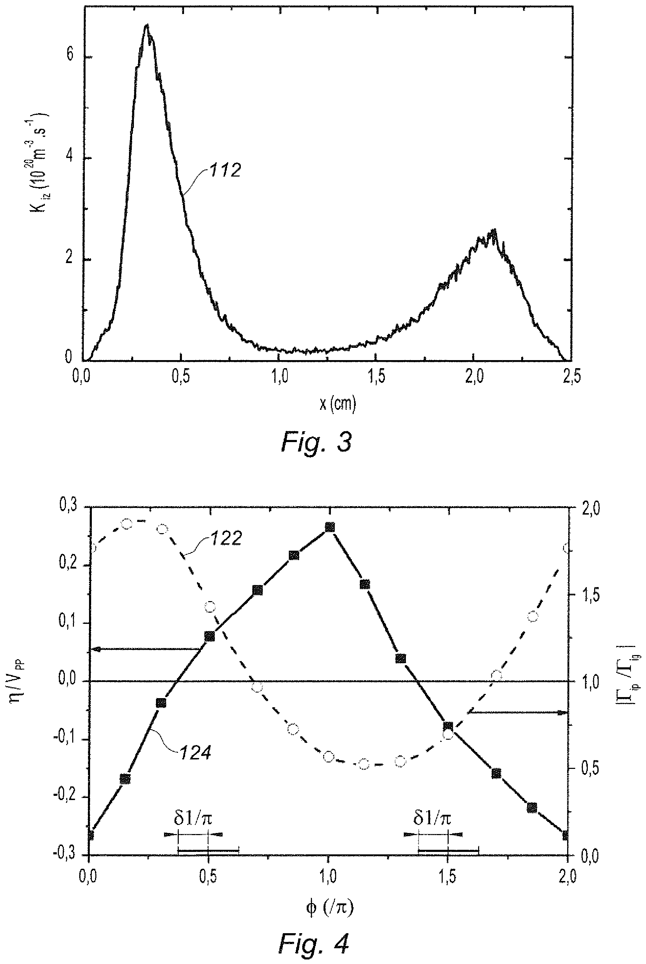

La Figure 3 est une vue d'un profil spatial de la vitesse d'ionisation moyenne dans le temps $\langle K_{iz} \rangle$ du plasma en fonction de la distance d'éloignement $\underline{x}$ séparant un point observé du plasma et l'électrode alimentée en énergie, pour une configuration de plasma dans laquelle le gaz est de l'argon sous une pression de 400mTorr et la forme d'onde est celle de la Figure 2 pour $\Phi = \pi/2$ et une tension crête-crête Vpp égale à 200V ;

La Figure 4 est une vue des évolutions respectives, en fonction d'un angle de decalage normalisé $\Phi/(/\pi)$ décrivant l'intervalle [0,2], de la tension d'autopolarisation normalisée $\eta/V_{pp}$ et du rapport des flux ioniques au niveau des électrodes, dans une configuration de plasma pour laquelle le gaz utilisé est de l'argon sous une pression P égale à 400mTorr, et la forme d'onde appliquée, composée de 4 harmoniques, vérifie l'équation,

$$V_{AC}(t) = V_0 \sum_{k=1}^{4} \frac{5-k}{4} \cos(k\omega t + \Phi)$$

avec une tension crête-crête Vpp égale à 200V;

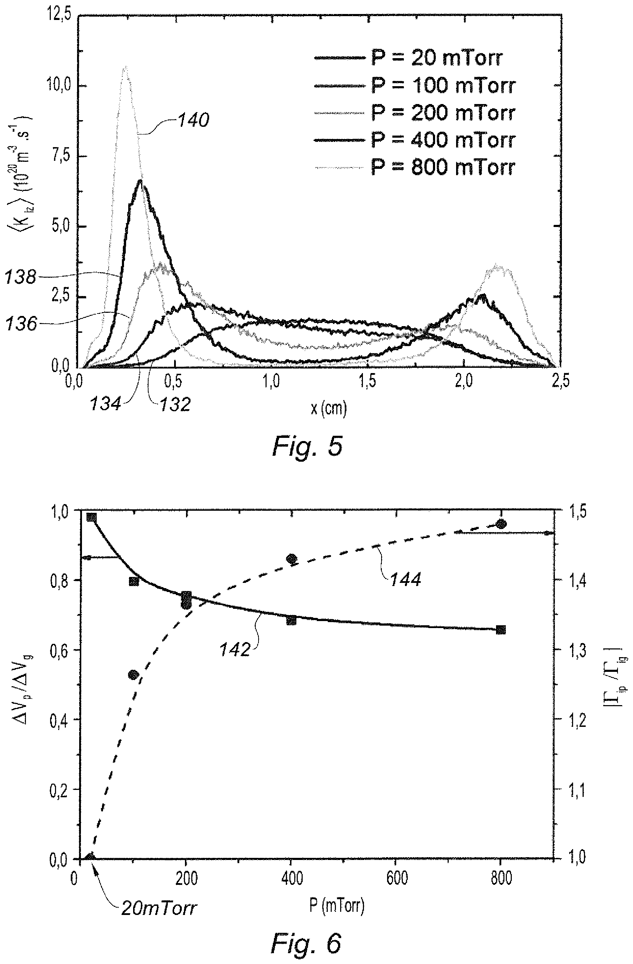

La Figure 5 est une vue d'un ensemble de courbes, paramétrées par la pression du gaz, d'évolutionde la vitesse d'ionisation moyenne dans le temps du plasma en fonction de la distance d'éloignement $\underline{x}$ séparant un point observé du plasma et la première électrode alimentée en énergie, pour une configuration de plasma dans laquelle le gaz est de l'argon et la forme d'onde est celle de la Figure 2 pour $\Phi = \pi/2$ et une tension crête-crête Vpp égale à 200V;

La Figure 6 est une vue des évolutions respectives, en fonction de la pression du gaz décrivant l'intervalle [1mTorr, 800 mTorr], du rapport de la différence des tensions de part et d'autre de la gaine en vis-à-vis de l'électrode alimentée en énergie et de la différence des tensions de part et d'autre de la gaine en vis-à-vis de l'électrode mise à la masse, $\Delta V_p / \Delta V_g$, et de la valeur absolue du rapport des flux ioniques au niveau des mêmes électrodes, $|\Gamma_{ip}/\Gamma_{ig}|$, pour une configuration de plasma dans laquelle le gaz est de l'argon et la forme d'onde est celle de la Figure 2 pour $\Phi = \pi/2$ et une tension crête-crête Vpp égale à 200V ;

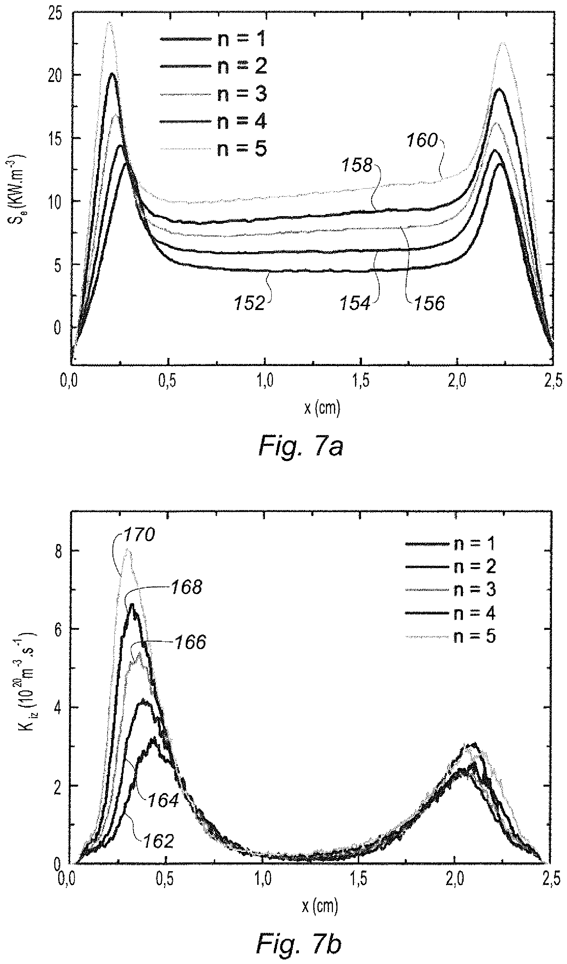

Les Figures 7a, 7b sont respectivement les vues de profils spatiaux, fonction de la distance $\underline{x}$ et paramétrés en fonction du nombre $\underline{n}$ d'harmoniques composant la forme d'onde d'excitation du plasma, de la vitesse de chauffage électronique moyenne dans le temps, $\langle S_e \rangle$, et de la vitesse d'ionisation moyenne dans le temps $\langle K_{iz} \rangle$ du plasma, pour une configuration du plasma dans laquelle le gaz utilisé est de l'argon sous une pression P égale à 400mTorr, et la forme d'onde appliquée, composée de n harmoniques, vérifie l'équation,

$$V_{AC}(t) = V_0 \sum_{k=1}^{n} \frac{n-k+1}{n} \cos(k\omega t + \Phi)$$

avec $\Phi = \pi/2$ et une tension crête-crête Vpp égale à 200V ;

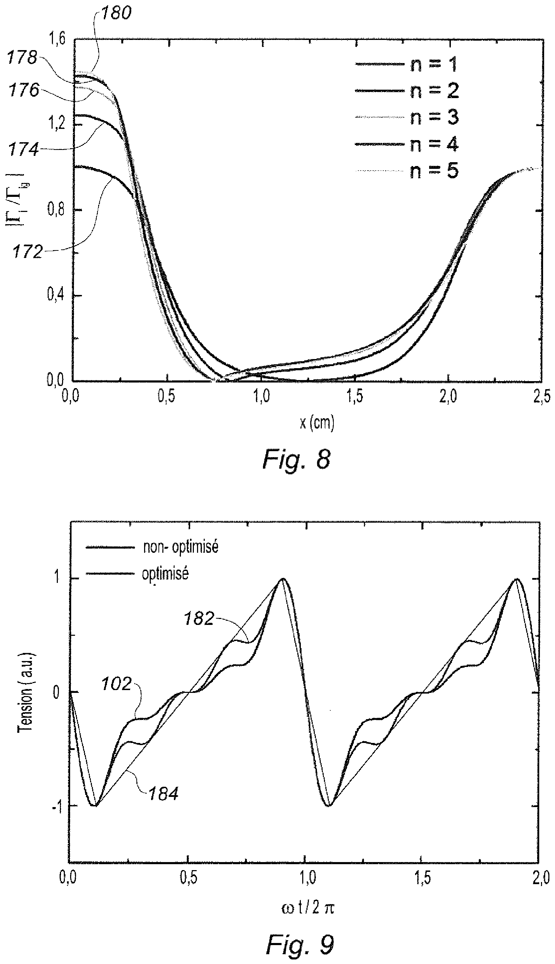

La Figure 8 est une vue de profils spatiaux suivant la distance $\underline{x}$, paramétrés en fonction du nombre $\underline{n}$ d'harmoniques, du flux d'ions normalisé, pour une même configuration de plasma que celle utilisée dans les Figure 7a et 7b ;

La Figure 9 est une vue comparative sur deux périodes temporelles de la première forme d'onde de la Figure 2 et d'une forme d'onde optimisée à quatre harmoniques dont la tension d'excitation $V_{AC}(t)$ avant normalisation vérifie

$$V_{AC}(t) = V_0 \sum_{k=1}^{4} \frac{1}{k} \cos(k\omega t + \frac{\pi}{2}) \ ,$$

l'équation

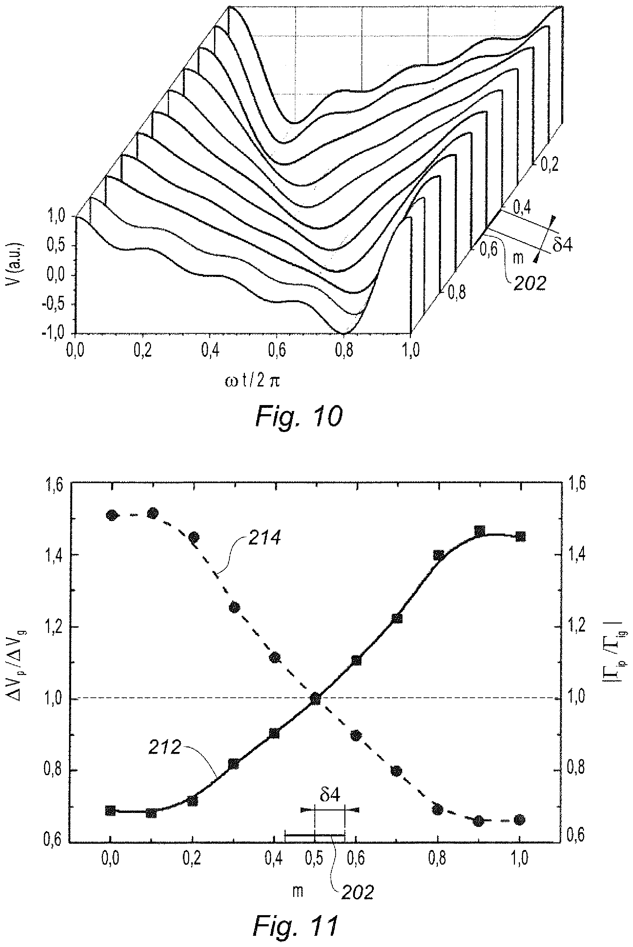

La Figure 10 est une vue d'un ensemble de formes d'onde, paramétrées par un paramètre m variant entre 0 et 1 et dont la tension d'excitation $V_{AC}(t)$ avant normalisation vérifie l'équation :

$$V_{AC}(t) = V_0 \sum_{k=1}^{4} \frac{2(-1)^k}{k^2 m(1-m)\pi^2} \sin(k(1-m)\pi) \sin(k\omega t) \ ,$$

qui privé des formes d'onde associées à $\underline{m}$

appartenant à un intervalle [0 5-$\delta_4$, 0,5+$\delta_4$] est une troisième forme de réalisation des formes d'ondes de l'invention ;

La Figure 11 est une vue de l'évolution en fonction du paramètre m, du rapport de la différence des tensions de part et d'autre de la gaine en vis-à-vis de la première électrode alimentée en énergie et de la différence des tensions de part et d'autre de la gaine en vis-à-vis de la deuxième électrode mise à la masse, $\Delta V_p/\Delta V_g$, et du rapport des flux ioniques au niveau des mêmes électrodes, $|\Gamma_{ip}/\Gamma_{ig}|$, pour une configuration de plasma dans laquelle le gaz est de l'argon et la forme d'onde est celle de la Figure 10 pour une tension crête-crête Vpp égale à 200V ;

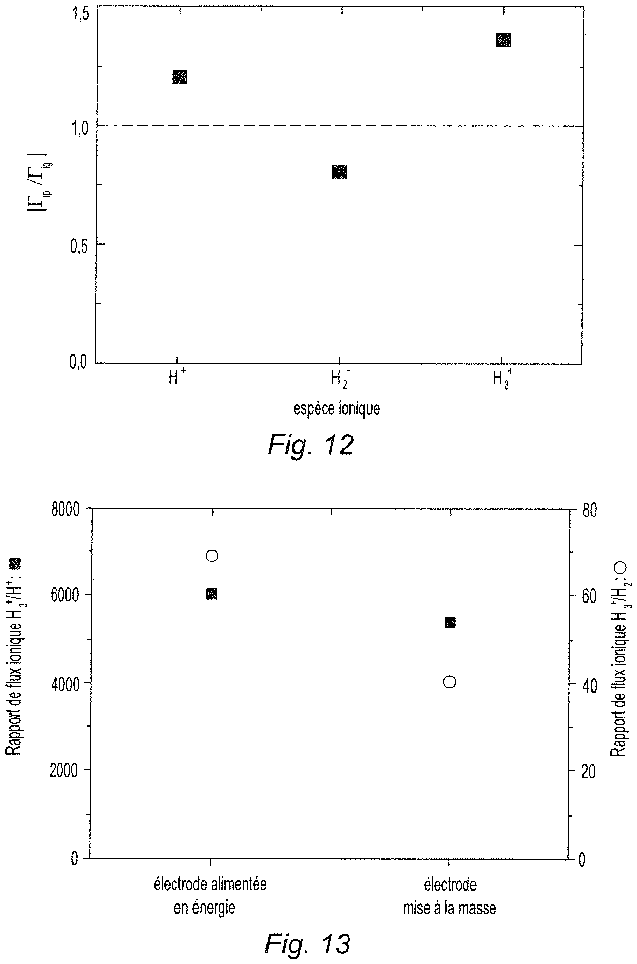

La Figure 12 est une vue de la valeur absolue, calculée à l'aide d'une simulation s'appuyant sur un modèle de dynamique des fluides, des rapports respectifs des flux ioniques au niveau niveau de l'électrode alimentée en énergie et de l'électrode mise à la masse $|\Gamma_{ip}/\Gamma_{ig}|$, pour les ions H$^+$, H$_2^+$ et H$_3^+$ pour une configuration de plasma dans laquelle le gaz est du dihydrogène sous une pression P de 850mTorr et la forme d'onde est la forme d'onde non optimisée à quatre fréquences de la Figure 9 avec une tension crête-crête Vpp égale à 200V ;

La Figure 13 est une vue des rapports de flux ioniques, calculée à l'aide d'une simulation s'appuyant sur un modèle de dynamique des fluides, entre H$_3^+$ et H$^+$, et entre H$_3^+$ et H$_2^+$, au niveau niveau de l'électrode alimentée en énergie et de l'électrode mise à la masse, pour une configuration de plasma dans laquelle le gaz est du dihydrogène sous une pression P de 850mTorr et la forme d'onde est la forme d'onde non optimisé à quatre fréquences de la Figure 9 avec une tension crête-crête Vpp égale à 200V ;

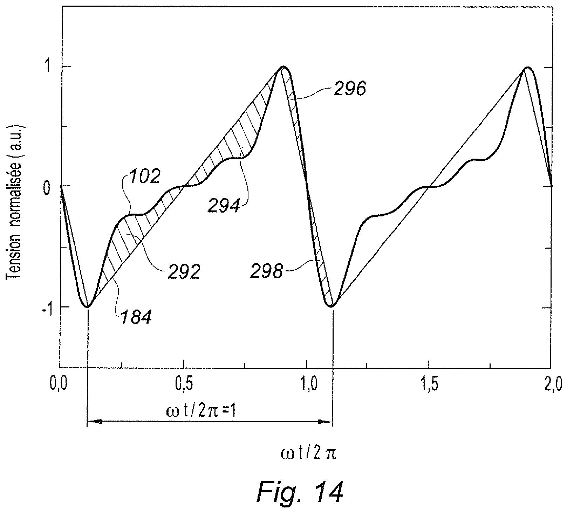

La Figure 14 est une vue géométrique permettant de visualiser une distance fonctionnelle séparant la première forme d'onde non optimisée normlisée de la Figure 9 et la fonction en dent de scie normalisée associée.

Selon l'invention et suivant la Figure 1, un système de traitement plasma 2 pour créer une asymétrie de flux ionique comprend un réacteur plasma RF 4 capacitivement couplé CCP contenant du gaz 6 ou un mélange de gaz, un substrat 8 à traiter, des moyens d'excitation 10 programmable du réacteur plasma 4, des moyens de mesure 12 de la forme d'onde de tension injectée à l'entrée 14 du réacteur 4, des moyens 16 de réglage de la pression totale P du gaz ou des gaz mélangés contenus dans le plasma, des moyens de suivi 18 du processus de traitement et de l'état de surface du substrat 8, et un calculateur électronique 20.

Le réacteur plasma 4 comprend une chambre de traitement 22, une première électrode 24 alimentée en énergie RF avec une première onde de tension RF, et une deuxième électrode 26, ici mise à une masse 28 et dépourvue d'alimentation.

En variante, la deuxième électrode est mise à un potentiel flottant, ou polarisée avec une deuxième onde de tension RF. Dans le cas où la deuxième électrode est polarisée, la première onde de tension RF sur la première électrode prend pour référence une masse externe qui sera de préférence identique à celle de la deuxième électrode.

Le substrat 8, destiné à être soumis au traitement plasma, est placé ici à titre illustratif sur la deuxième électrode 26 mise à la masse ou dépourvue d'alimentation électrique. En variante, le substrat 8 à traiter est disposé à proximité de la première électrode 24, alimentée en énergie RF. Dans la pratique, le choix du positionnement du substrat 8 dépendra de la reaction chimique que l'on cherchera à favoriser ou éviter.

Les moyens d'excitation programmable 10 comprennent, connectés en série, un générateur de forme d'onde de tension programmable 32, un amplificateur de puissance RF 34 et une capacité de couplage 36, la capacité de couplage 36 étant connectée entre la première électrode 24 du réacteur 4 et la sortie de l'amplificateur 34 de puissance RF. Le générateur de forme d'onde 32 comporte une borne d'entrée 38, connectée au calculateur 20 pour recevoir de ce dernier des paramètres caractéristiques de la forme d'onde à générer.

Les moyens de mesure 12 de la forme d'onde de tension injectée à l'entrée 14 du réacteur 4 comprennent une sonde Haute Tension (HT) 42 branchée sur l'entrée 14 du réacteur 4 pour mesurer la tension d'excitation injectée au niveau de la première électrode 24 et un oscilloscope 44 pour recevoir, à chaque instant en une borne d'entrée 46 et en provenance de la sonde, la tension d'excitation mesurée au niveau de la première électrode 24. L'oscilloscope 44 comporte une borne de sortie 50, connectée au calculateur 20 pour délivrer à ce dernier le signal d'évolution temporelle de la forme d'onde d'excitation mesurée en l'entrée 14.

Le calculateur électronique 20 comporte une première borne de sortie 52, connectée au générateur de forme d'onde 32 par la borne d'entrée 38, pour fournir au générateur de forme d'onde 32 des commandes sous la forme de paramètres caractéristiques de la forme d'onde à générer. Le calculateur 20 est configuré pour recevoir le signal d'évolution temporelle de la forme d'onde d'excitation mesurée fournie par l'oscillospe 44, pour analyser la forme d'onde mesurée, par exemple en la décomposant sur une base de signaux adaptés, pour comparer ensuite la forme d'onde mesurée et analysée à la forme d'onde souhaitée selon l'invention au niveau de la première électrode 24, et pour corriger, en fonction du résultat de comparaison, la forme d'onde mesurée en modifiant les paramètres caractéristiques de la forme d'onde générée par le générateur de forme d'onde programmable 32.

Ainsi, les formes d'onde désirées sur la première électrode 24 sont produites en utilisant une boucle de rétroaction 54, réalisée par la chaîne des composants connectés en série que sont le générateur de forme d'onde 32, l'amplificateur de puissance RF 34, la capacité de couplage 36, la sonde HT 42, l'oscilloscope 44 et le calculateur 20.

Le calculateur 20 comporte également ici une deuxième borne de sortie 56, connectée en entrée aux moyens de réglage 16 de la pression P du gaz pour fournir une consigne de pression souhaitée du gaz 6 contenu dans le réacteur 4.

En variante, la consigne de pression totale souhaitée du gaz 6 ou des gaz mélangés contenus dans le réacteur 4 est fournie manuellement.

Le générateur de forme d'onde de tension programmable 32 est configuré pour générer une forme d'onde de tension radio-fréquence (RF) V(t) ayant une fréquence inférieure correspondant à un harmonique fondamental de la forme d'onde, une amplitude maximale positive notée $V_{max}$ et une amplidude minimale négative notée $V_{min}$. Les valeurs absolues de ces amplitudes, $V_{max}$ et $-V_{min}$, sont supposées ici égales mais en variante peuvent être différentes.

Une forme d'onde de tension, normalisée en amplitude et en temps, notée f(u), peut être définie à partir de la forme d'onde V(t) par une transformation dans laquelle u=t/T, et $f_{max}$=-$f_{min}$=1 avec $f_{max}$ et $f_{min}$ correspondant respectivement à $V_{max}$ et $V_{min}$.

La forme d'onde de tension, normalisée en amplitude et en temps,

$$f(u) = \frac{V(uT) - \left((V_{max} + V_{min})/2\right)}{(V_{max} - V_{min})/2}$$

notée f(u) est ici définie par l'équation :

La forme d'onde de tension, normalisée en amplitude et en temps, f(u) est une forme d'onde approchée avec un degré d'approximation d'une fonction radiofréquence en dent de scie normalisée en amplitude et en temps $f_{SAW}(u)$.

La fonction radiofréquence en dent de scie normalisée présente un motif périodique de période fondamentale consistant T en une première portion linéaire d'évolution temporelle de la tension normalisée avec une première pente p1, suivie immédiatement d'une deuxième portion linéaire d'évolution temporelle de la tension normalisée avec une deuxième pente p2, les premiere et deuxième pentes p1, p2 étant d'amplitudes différentes et de signes opposés, le minimum et le maximum du motif ayant la même amplitude unitaire.

Le degré d'approximation de la forme d'onde approchée et la pression P du gaz sont choisis suffisamment grands pour faire apparaître une asymétrie des flux ioniques entre le flux ionique au niveau de la première électrode 24 et le flux ionique au niveau de la deuxième électrode 26.

La forme d'onde de tension radio-fréquence périodique V(t) est dérivable et présente une asymétrie de pente mesurée par un facteur d'asymétrie de pente F paramétré par un entier p supérieur ou égal à 1 et défini par l'équation :

$$F(p) = \left| \frac{\int\limits_{t\in[0,T],V'>0}\left|(V'(t))^p\right| - \int\limits_{t\in[0,T],V'<0}\left|(V'(t))^p\right|}{\int\limits_{t\in[0,T]}\left|(V't))^p\right|} \right|$$

V'(t) désignant la dérivée de la forme d'onde à l'instant t.

Le numérateur de F(p) représente la différence entre une première moyenne $m_+(p)$ sur un motif périodique des pentes positives de la forme d'onde V(t) et une deuxième moyenne $m_-(p)$ sur le même motif périodique des pentes négatives de la forme d'onde V(t).

Le dénominateur de F(p) représente une mesure de la norme de la dérivée de la forme d'onde périodique.

La forme d'onde présente une asymétrie de pente suffisante pour observer un effet d'asymétrie de flux ionique sur les première et deuxième électrode lorsque F(p) est supérieur ou égal à un seuil, lequel seuil dépend de l'entier p.

De préférence, p est fixé à 2. Dans ce cas, la forme d'onde présente une asymétrie de pente suffisante pour observer un effet d'asymétrie de flux ionique sur les première et deuxième électrode lorsque F(2) est supérieur ou égal à un seuil égal à 0,1.

Parmi des conditions nécessaires mais non suffisantes pour que la forme d'onde présente une asymétrie de présente, il convient de mentionner les deux conditions nécessaires suivantes.

Selon une première condition, la forme d'onde de tension approchée après normalisation f(u) doit est une forme d'onde non invariante par retournment temporel, c'est-à-dire une forme d'onde pour laquelle il n'existe pas de constante réelle $\tau$ vérifiant :

f(u) = f($\tau$ - u), u désignant la variable d'évolution temporelle normalisée dee la forme d'onde de tension approchée normalisée.

Selon une deuxième condition, pour chaque maximum courant de la forme d'onde de tension approchée normalisée identifié par un indice de parcours j, la durée séparant l'instant d'occurrence t(max(j)) du maximum courant de l'instant d'occurrence t(min(j)) du premier mimimum min(j) suivant le maximum courant max(j), est différente de la durée séparant l'instant d'occurence t(max(j+1)) du premier maximum max(j+1) succédant immédiament au premier mimimum min(j) et l'instant d'occurrence t(min(j)) du premier minimum min(j).

Ces deux conditions sont satisfaites lorsque un facteur d'asymétrie de pente de pente F(p) est différent de zéro, pour une valeur de l'entier p quelconque.

De même, ces deux conditions sont satisfaites lorsque la forme d'onde normalisée approche suffisamment une fonction en dent de scie dont les pentes de signes p1 et p2 opposées ont des valeurs absolues différentes.

Suivant la Figure 2 et un premier mode de réalisation de l'invention, une première courbe 102 représente l'évolution temporelle de la tension d'excitation $V_{AC}(t)$ normalisée d'une première forme d'onde, la tension d'excitation

$$V_{AC}(t) = V_0 \sum_{k=1}^{4} \frac{5-k}{4} \cos(k\omega t + \Phi)$$

$V_{AC}(t)$ avant normalisation vérifiant l'équation pour une valeur particulière de $\Phi$ égale à $\pi/2$.

$V_0$ désigne un facteur de tension, $\omega$ est la pulsation, correspondant ici à une fréquence fr de 13,56 MHz ($\omega = 2\pi$fr). $V_0$ est ici fixé pour donner la tension crête-crête $V_{pp}$ souhaitée égale à 200V

Une deuxième courbe 104 représente l'évolution temporelle de la tension d'excitation $V_{AC}(t)$ normalisée d'une deuxième forme d'onde, la tension d'excitation $V_{AC}(t)$ avant normalisation vérifiant l'équation

$$V_{AC}(t) = V_0 \sum_{k=1}^{4} \frac{5-k}{4} \cos(k\omega t + \Phi)$$

pour une valeur de $\Phi$ égale à $3\pi/2$.

Pour ces deux formes d'onde, l'asymétrie d'amplitude estimée à l'aide d'un facteur a, égal à moins le rapport du maximum sur le minimum de la tension $V_{AC}(t)$ de la forme d'onde est égal à 1. Ainsi dans ce cas, l'asymétrie ne provient pas de l'effet d'amplitude.

La première forme d'onde 102 présente sur la durée d'une période une première portion de signal croissant en étant globalement proche d'une première rampe avec une pente positive p1 égale à environ 2,5, et une deuxième portion de signal décroissant en étant globalement proche d'une deuxième rampe avec une deuxième pente négative p2 égale à environ -10.

De manière similaire, la deuxième forme d'onde 104 présente sur la durée d'une période une première portion de signal décroissant en étant globalement proche d'une première rampe avec une pente négative égale à environ -2,5, et une deuxième portion de signal croissant en étant globalement proche d'une deuxième rampe avec une deuxième pente positive égale à environ 10.

Ainsi, les première et deuxième formes d'onde de tension du premier mode de réalisation de l'invention peuvent elles être considérées comme une forme d'onde approchée avec un certain degré d'approximation respectivement d'une première fonction radiofréquence en dent de scie et d'une deuxième fonction radiofréquence en dent de scie, les pentes des rampes (p1 ; p2) des première et deuxième fonctions radiofréquence en dent de scie normalisées en amplitude étant respectivement égales à (2,5 ; -10) et (-2,5 ; 10).

Suivant la Figure 3, une troisième courbe 112 décrit un profil spatial, calculé à l'aide d'une simulation de type PIC (en anglais Particle-In-Cell) de la vitesse d'ionisation moyenne dans le temps $\langle K_{iz} \rangle$ du plasma en fonction de la distance d'éloignement x séparant un point observé du plasma et la première électrode alimentée en énergie.

Le profil est ici calculé pour une configuration de plasma dans laquelle le gaz est de l'argon sous une pression de 400mTorr et la forme d'onde est celle de la Figure 2 pour $\Phi = \pi/2$ et une tension crête-crête Vpp égale à 200V.

Le signal d'excitation a créé dans le plasma une distribution spatiale asymétrique de la densité d'électrons énergétiques, c'est-à-dire une densité d'électrons énergétiques plus élevée sur une électrode, ici la première électrode 24 alimentée en énergie RF, que sur l'autre, ici la deuxième électrode 26 mise à la masse. Grâce à cela, le taux de création d'espèces chimiques qui dépend des gaz injectés, ici de l'argon, va également présenter une distribution spatiale asymétrique, illustré sur la Figure 3, où la vitesse d'ionisation moyenne dans le temps $\langle K_{iz} \rangle$ du plasma est deux fois plus élevée au niveau de la première électrode 24 que celle observée au niveau de la deuxième électrode 26.

Cela permet d'augmenter le flux arrivant sur une électrode, ici la première électrode 24, afin de pouvoir par exemple, déposer ou graver plus rapidement un matériau. Cette augmentation de flux sur la première électrode 24 se fait sans augmentation de l'énergie des ions.

Avantageusement, le flux d'ions peut être plus faible sur l'autre électrode, ici la deuxième électrode 26.

Un tel effet permet d'augmenter le rendement du processus de traitement plasma du substrat, soit en déposant, ou en gravant, ou en modifiant la surface d'intérêt du substrat plus rapidement sur la première électrode, et en diminuant ainsi le temps nécessaire au dépôt, ou à la gravure, ou à la modification de la surface d'intérêt, soit en réduisant le dépôt, ou la gravure, ou la modification de la surface d'intérêt sur la deuxième électrode, et en réduisant ainsi le temps de maintenance de la deuxième électrode pour nettoyage ou remplacement.

Il est à remarquer que pour observer cet effet d'asymétrie de pente, il est nécessaire que la pression du gaz soit suffisante, c'est à dire ici dans le cas de l'argon, supérieure ou égale à 100 mTorr.

Ici, le nombre d'harmoniques constituant la première forme d'onde est égale à 4, ce qui constitue un bon compromis entre la capacité d'approximation d'un signal en dent de scie et la simplicité de réalisation de la forme d'onde d'excitation.

Suivant la Figure 4, une première courbe 122 décrit l'évolution de la tension d'autopolarisation normalisée $\eta/V_{pp}$ en fonction d'un angle de decalage normalisé $\Phi(/\pi)$ décrivant l'intervalle [0,2], calculée par simulation dans une configuration de plasma pour laquelle le gaz utilisé est de l'argon sous une pression P égale à 400mTorr, et la forme

$$V_{AC}(t) = V_0 \sum_{k=1}^{4} \frac{5-k}{4} \cos(k\omega t + \Phi)$$

d'onde appliquée, composée de 4 harmoniques, vérifie l'équation, avec une tension crête-crête Vpp égale à 200V.

Une deuxième courbe 124 décrit l'évolution du rapport des flux ioniques au niveau des électrodes en fonction de l'angle de decalage normalisé $\Phi(/\pi)$ pour la même configuration de plasma.

Tandis que la tension d'autopolarisation $\eta$ est positive pour un décalage de phase $\Phi=\pi/2$, ce qui correspond à la première forme d'onde de la Figure 2, elle est négative pour $\Phi=3\pi/2$, ce qui correspond à la deuxième forme d'onde de la Figure 2.

Le rapport des flux ioniques au niveau des électodes ($|\Gamma_{ip}/\Gamma_{ig}|$), défini comme la valeur absolue du rapport du flux $\Gamma_{ip}$ des ions arrivant à la première électrode alimentée en énergie RF sur le flux $\Gamma_{ig}$ des ions arrivant à la deuxième électrode 26 mise à la masse, est supérieur à l'unité pour $\Phi=\pi/2$, et inférieur à l'unité pour $\Phi=3\pi/2$, ce qui montre l'effet d'asymétrie de pente dans ces deux cas remarquables.

Pour les deux formes d'ondes sont ainsi obtenus le flux ionique le plus grand pour l'énergie de bombardement ionique IBE (en anglais pour Ion Bombardment Energy) la plus faible. Ces deux optimums correspondent à la première électrode 24 alimentée en énergie dans le cas $\Phi=\pi/2$, et à la deuxième électrode 26 mise à la masse dans le cas $\Phi=3\pi/2$.

Les deux courbes 122 et 124 permettent d'élargir, suivant un deuxième mode de réalisation de l'invention, la classe des deux fonctions décrites à la Figure 2, à un deuxième ensemble de fonctions approximant les deux mêmes fonctions en dent de scie asymétriques en pente que celles associées aux première et deuxième formes d'ondes de la Figure 2. Les fonctions du deuxième ensemble de formes d'ondes de tension selon l'invention vérifient l'équation ;

$$V_{AC}(t) = V_0 \sum_{k=1}^{4} \frac{5-k}{4} \cos(k\omega t + \Phi)$$

avec

$$\Phi \in \left[\pi/2 - \delta 1, \pi/2 + \delta 1\right] \cup \left[3\pi/2 - \delta 1, 3\pi/2 + \delta 1\right].$$

$\delta 1$ est choisi égal inférieur ou égal à $\pi/4$, de préférence inférieur ou égal à $\pi/6$, et encore plus de préférence inférieur ou égal à $\pi/8$.

Suivant la Figure 5, des première, deuxième, troisième, quatrième, cinquième courbes, 132, 134, 136, 138, 140, paramétrées les valeurs de pression du gaz respectivement égales à 20 mTorr, 100 mTorr, 200 mTorr, 400 mTorr, 800 mTorr, représentent l'évolution de la vitesse d'ionisation moyenne dans le temps du plasma $\langle K_{iz}\rangle$ en fonction de la distance d'éloignement x séparant un point observé du plasma et la première électrode 24 alimentée en énergie, pour une configuration de plasma dans laquelle le gaz est de l'argon et la forme d'onde est celle de la Figure 2 pour $\Phi = \pi/2$ et une tension crête-crête Vpp égale à 200V.

Pour la pression P la plus basse égale à 20 mTorr, la première courbe 132 montre que l'ionisation a lieu dans le cœur du plasma et présente un profil symétrique autour d'un axe médian séparant la première électrode et la deuxième électrode.

Lorsque P augmente, l'ionisation a lieu de plus en plus à proximité des électrodes et une nette asymétrie apparait entre le côté de la première électrode 24 et le côté de la deuxième électrode 26.

Suivant la Figure 6, une première courbe 142 et une deuxième courbe 144 représentent les évolutions respectives, en fonction de la pression du gaz décrivant l'intervalle [1mTorr, 800 mTorr], du rapport de la différence des tensions de part et d'autre de la gaine en vis-à-vis de l'électrode alimentée en énergie et de la différence des tensions de part et d'autre de la gaine en vis-à-vis de l'électrode mise à la masse, $\Delta V_p/\Delta V_g$, et du rapport des flux ioniques au niveau des mêmes électrodes, $|\Gamma_{ip}/\Gamma_{ig}|$, pour une configuration de plasma dans laquelle le gaz est de l'argon et la forme d'onde est celle de la Figure 2 pour $\Phi = \pi/2$ et une tension crête-crête Vpp égale à 200V ;

Comme le montre la Figure 6, à une très basse pression, ici P=20 mTorr pour du gaz argon, aucune asymétrie ne peut être mise en évidence. Il est à remarquer que l'augmentation du degré d'asymétrie, en termes d'énergie de bombardement IBE maximum comme de flux ionique, n'est pas linéaire avec l'augmentation de la pression P. L'asymétrie est détectable à partir de 100 mTorr, augmente nettement à 200mTorr environ, et ensuite croit plus lentement.

Selon les Figures 5 et 6, la pression est jugée suffisante pour faire apparaître une asymétrie du flux ionique lorsque la pression P du gaz est supérieure ou égale à 100 mTorr, que le gaz est de l'argon et que la forme d'onde est celle de la Figure 2 pour $\Phi = \pi/2$. Cette valeur de pression seuil est sensiblement identique lorsque la forme d'onde est la forme d'onde de la dent de scie correspondant à la première forme d'onde de la Figure 2.

De manière générale, la pression P du gaz est jugée suffisante pour créer une asymétrie du flux ionique lorsque la pression P est supérieure ou égale à une valeur seuil de pression $P_s(gaz)$, dépendant de la nature du gaz et définie comme la pression au-dessus de laquelle une asymétrie du flux ionique apparait nettement entre le flux ionique au niveau de la première électrode et le flux ionique au niveau de la deuxième électrode, et lorsque la forme d'onde normalisée d'excitation est une fonction en dent de scie normalisée pour laquelle la valeur absolue de la pente la plus douce est égale à 2,5. Une valeur seuil de pression $P_s(gaz)$, dépendant de la nature du gaz peut être définie comme la pression au-dessus de laquelle une asymétrie du flux ionique apparait nettement entre le flux ionique au niveau de la première électrode et le flux ionique au niveau de la deuxième électrode, et lorsque la forme d'onde normalisée d'excitation

$$V_{AC}(t) = V_0 \sum_{k=1}^{4} \frac{n-k+1}{n}\cos(k\omega t + \Phi)$$

est exprimée par l'équation, avec $\Phi = \pi/2$ ou lorsque la forme d'onde est une forme d'onde dont le facteur d'asymétrie de pente F(2) est égal à 0,1.

Suivant la Figure 7a des premier, deuxième, troisième, quatrième, cinquième profils spatiaux, 152, 154, 156, 158, 160, paramétrés respectivement en fonction du nombre $\underline{n}$ variant de 1 à 5 d'harmoniques composant la forme d'onde d'excitation du plasma, illustrent les variations de la vitesse de chauffage électronique moyenne dans le temps, $\langle S_e \rangle$, en fonction de la distance $\underline{x}$, pour une configuration du plasma dans laquelle le gaz utilisé est de l'argon sous une pression P égale à 400mTorr, et la forme d'onde appliquée, composée de n harmoniques, vérifie l'équation,

$$V_{AC}(t) = V_0 \sum_{k=1}^{n} \frac{n-k+1}{n}\cos(k\omega t + \Phi)$$

avec $\Phi = \pi/2$ et une tension crête-crête Vpp égale à 200V ;

Suivant la Figure 7b, des premier, deuxième, troisième, quatrième, cinquième profils spatiaux, 162, 164, 166, 168, 170, paramétrés respectivement en fonction du nombre $\underline{n}$ variant de 1 à 5 d'harmoniques composant la forme d'onde d'excitation du plasma, illustrent les variations de la vitesse d'ionisation moyenne dans le temps $\langle K_{iz} \rangle$ du plasma en fonction de la distance $\underline{x}$ pour une configuration de plasma identique à celle de la Figure 7a.

Suivant la Figure 7a, lorsque le nombre d'harmoniques $\underline{n}$ augmente, le premier maximum de $\langle S_e \rangle$ se rapproche de la première électrode alimentée en énergie RF tandis que le deuxième maximum se déplace à peine vers la deuxième électrode 26 mise à la masse, ce qui signifie que l'épaisseur de la gaine diminue seulement pour celle située en vis-à-vis de la première électrode 24 alimentée en énergie.

Sur la Figure 7a seules de faibles différences d'amplitudes des maxima de $\langle S_e \rangle$ à proximité des électrodes peuvent être être observées.

A l'inverse sur la figure 7b, une nette différence est perceptible entre deux maxima du profil de la vitesse d'ionisation moyenne dans le temps $\langle K_{iz} \rangle$. La valeur du maximum de $\langle K_{iz} \rangle$ à proximité de la première électrode 24 alimentée en énergie est supérieure à au moins deux fois la valeur du maximum de $\langle K_{iz} \rangle$ à proximité de la deuxième électrode 26 mise à la masse pour $\underline{n}$ supérieur ou égal à 4.

Comme conséquence de l'asymétrie qui apparaît dans le profil de $\langle K_{iz} \rangle$ lorsque $\underline{n}$ est supérieur ou égal à 2, le flux ionique est différent d'une électrode à l'autre comme le montre la Figure 8.

Suivant la Figure 8, les flux ioniques, représentés par des courbes 172, 174, 176, 178, 180 respectivement associés à un nombre d'harmoniques $\underline{n}$ variant de 1 à 5, sont normalisés par rapport au flux ionique observé sur la deuxième électrode 26 mise à la masse. Le flux ionique sur la première électrode 24 peut dépasser de 40% celui sur la deuxième électrode 26 mise à la masse. En effet, tandis que le flux ionique augmente légèrement au niveau de la deuxième électrode 26 mise à la masse lorsque le nombre d'harmoniques $\underline{n}$ augmente de 1 à 5, en même temps le flux ionique sur la première électrode alimentée en énergie devient double.

$$V_{AC}(t) = V_0 \sum_{k=1}^{n} \frac{n-k+1}{n}\cos(k\omega t + \Phi)$$

L'équation des formes d'onde de tension qui s'écrit : avec $\Phi$

= $\pi/2$, permet d'élargir suivant un troisième mode de réalisation de l'invention, la classe des fonctions décrites par cette équation et limitées à une valeur de $\Phi = \pi/2$, à un troisième ensemble de fonctions approximant toujours les deux mêmes fonctions en dent de scie asymétriques en pente que celles associées aux première et deuxième formes d'ondes de la Figure 2. Les fonctions du troisième ensemble de formes d'ondes de tension selon l'invention vérifient l'équation ;

$$V_{AC}(t) = V_0 \sum_{k=1}^{n} \frac{n-k+1}{n} \cos(k\omega t + \Phi)$$

avec

$$\Phi \in \left[\pi/2 - \delta 2, \pi/2 + \delta 2\right] \cup \left[3\pi/2 - \delta 2, 3\pi/2 + \delta 2\right].$$

$\delta 2$ est choisi inférieur ou égal à $\pi/4$, de préférence inférieur ou égal à $\pi/6$, et encore plus de préférence inférieur ou égal à $\pi/8$.

Suivant la Figure 9, une forme d'onde optimisée 182 de la première forme d'onde 102 non optimisée de la Figure 2 est rendue plus proche de la fonction en dent de scie 184 correspondant à la forme d'onde 102 non optimisée en minimisant les deux fronts montants les plus raides de la première forme d'onde 102 non optimisée. L'équation de la forme d'onde optimisée 182 s'écrit :

$$V_{AC}(t) = V_0 \sum_{k=1}^{4} \frac{1}{k} \cos(k\omega t + \frac{\pi}{2}),$$

dans laquelle $V_0$ désigne un facteur de tension, $\omega$ est la pulsation, correspondant ici à une fréquence f de 13,56 MHz ($\omega = 2\pi f$). $V_0$ est ici fixé pour donner la tension crête-crête $V_{pp}$ souhaitée égale à 200V

A l'instar de ce qui a été fait pour le troisième mode de réalisation, l'équation de la forme d'onde optimisée 182 permet d'élargir suivant un quatrième mode de réalisation de l'invention, la classe des fonctions décrites par l'équation

$$V_{AC}(t) = V_0 \sum_{k=1}^{4} \frac{1}{k} \cos(k\omega t + \frac{\pi}{2})$$ limitées à une valeur de $\Phi = \pi/2$ et à un nombre $\underline{n}$ d'harmoniques égal à 4, à un quatrième ensemble de fonctions approximant toujours les deux mêmes fonctions en dent de scie asymétriques en pente que celles associées aux première et deuxième formes d'ondes de la Figure 2. Les fonctions du quatrième ensemble de formes d'ondes de tension selon l'invention vérifient l'équation :

$$V_{AC}(t) = V_0 \sum_{k=1}^{n} \frac{1}{k} \cos(k\omega t + \Phi),$$

dans laquelle $\underline{n}$ désigne un nombre d'harmoniques supérieur ou égal à 2, et $\Phi$ désigne un angle de déphasage uniforme entre les harmoniques tel que $\Phi \in [\pi/2 - \delta 3, \pi/2 + \delta 3] \cup [3\pi/2 - \delta 3, 3\pi/2 + \delta 3]$.

$\delta 3$ est choisi inférieur ou égal à $\pi/4$, de préférence inférieur ou égal à $\pi/6$, et encore plus de préférence inférieur ou égal à $\pi/8$.

Suivant un cinquième mode de réalisation de formes d'onde selon l'invention, il est possible de faire varier continûment l'asymétrie de la décharge en utilisant un ensemble de formes d'onde définies par l'équation :

$$V_{AC}(t) = V_0 \sum_{k=1}^{n} \frac{2(-1)^k}{k^2 m(1-m)\pi^2} \sin(k(1-m)\pi) \sin(k\omega t),$$

dans laquelle $\underline{n}$ est le nombre d'harmoniques, et $\underline{m}$ est un paramètre tel que le minimum de la forme d'onde serait à une fraction $\underline{m}$ d'une période lorsque la forme d'onde est composée d'un nombre infini de fréquences. Lorsque $\underline{m}$ approche 0, la forme d'onde approche de la manière optimisée la forme d'onde en dent de scie montante ($\Phi = \pi/2$) tronquée au rang d'harmonique n. Lorsque $\underline{m}$ approche 1, la forme d'onde approche de la manière optimisée décrite à la Figure 9 la forme d'onde en dent de scie descendante ($\Phi = 3\pi/2$), c'est à dire présentant une pente de descente plus douce que la pente de montée, tronqué au rang n. Les valeurs de m proches ou égale à 0.5, correspondant à des formes d'onde proches ou égale à celles d'un triangle, tronqué au rang d'harmonique n et symétrique, doivent être enlevées. Ainsi m doit vérifier la condition :

$$m \in \left]0; 0,5 - \delta 4\right] \cup \left[0,5 + \delta 4 ; 1\right]$$

$\delta 4$ est choisi supérieur ou égal à 0,1, de préférence supérieur ou égal à 0,2.

Suivant la Figure 10, onze formes d'onde, paramétrées par 11 valeurs différentes du paramètre m variant entre 0 et 1 sont décrites dans le cas où le nombre n d'harmoniques est fixé à 4. Dans ce cas, la tension d'excitation $V_{AC}(t)$ des formes d'ondes avant normalisation vérifient l'équation :

$$V_{AC}(t) = V_0 \sum_{k=1}^{4} \frac{2(-1)^k}{k^2 m(1-m)\pi^2} \sin(k(1-m)\pi) \sin(k\omega t).$$

L'intervalle des valeurs de m à enlever [0 5-$\delta 4$, 0,5+$\delta 4$] est représenté sur Figure 10 et désigné par la référence 202.

La Figure 11 illustre l'effet de la variation de m sur l'asymétrie de la décharge pour une configuration de plasma dans laquelle le gaz est de l'argon soumis à un une pression égale à 400 mTorr et la forme d'onde est une forme d'onde modulée par le paramètre m dont le nombre d'harmoniques est égal à 4 et la tension crête-crête Vpp est égale à 200V.

Une première courbe 212 représente l'évolution du rapport de la tension à travers la gaine voisine de la première electrode 24 alimentée et de la tension à travers la gaine en vis-à-vis de la deuxième electrode 26 mise à la masse, $\Delta V_p / \Delta V_g$, en fonction du paramètre m.

Une deuxième courbe 214 illustre l'évolution de la valeur absolue du rapport des flux ioniques au niveau des mêmes électrodes, $|\Gamma_{ip}/\Gamma_{ig}|$

Comme attendu, l'effet pour m'=1-m est inverse à celui de m. De plus, lorsque m approche 0,5 par valeur inférieure ou supérieure, l'asymétrie diminue. Ainsi, l'expression analytique décrite dans l'équation des formes d'onde du cinquième mode de réalisation est un moyen pour faire varier de manière continue l'asymétrie de décharge.

Il est à remarquer que l'asymétrie ne diminue pas lorque m augmente de 0 à 0,1. Cela provient du fait que la pente négtive ne change pas de manière significative tandis que la pente positive est adoucie et donc les montées abrupte sont limitées. L'effet est ensuite à peu près linéaire losque 0,1 <m<0,9.

Suivant la Figure 12, sont illustrés les rapports respectifs des flux ioniques au niveau de l'électrode alimentée en énergie et de l'électrode mise à la masse $|\Gamma_{ip}/\Gamma_{ig}|$,, pour les ions $H^+$, $H_2^+$, $H_3^+$ et pour une configuration de plasma dans laquelle le gaz est du dihydrogène et la forme d'onde est la forme d'onde non optimisée 102 à quatre fréquences de la Figure 9 avec une tension crête-crête Vpp égale à 200V.

Suivant la Figure 13, sont représentés les rapports de flux ioniques entre $H_3^+$ et $H^+$, et entre $H_3^+$ et $H_2^+$ sur chaque électrode pour la même configuration de plasma que celle de la Figure 12.

Les Figures 12 et 13 montrent ainsi que lorsque plusieurs espèces chimiques sont présentes dans le plasma, comme par exemple les espèces $H_2^+$, $H_3^+$, pour un gaz d'hydrogène, il peut être avantageux de créer des espèces proches d'une électrode si ces espèces sont à la fois, très réactives dans le sens où elles ne peuvent parcourir qu'une faible distance avant de disparaître en créant d'autres espèces, et bénéfiques au processus de traitement ayant lieu sur l'électrode. Inversement, il peut être utile de ne créer ces espèces que loin d'une électrode dans le cas où celles-ci seraient peu réactives et agiraient au détriment du processus ayant lieu sur ladite électrode. On peut alors supposer que leur densité sera plus faible à proximité de l'électrode.

De manière générale, un procédé selon l'invention de génération d'une asymétrie de flux ionique dans un réacteur plasma RF capacitivement couplé, contenant un gaz sous une pression P, et comportant une première électrode, alimentée en énergie radiofréquence, et une deuxième électrode mise à la masse, comprend une étape d'excitation de la première électrode par une forme d'onde de tension radio-fréquence ayant une fréquence inférieure correspondant à un harmonique fondamental de la forme d'onde.

La forme d'onde de tension normalisée en amplitude et en temps est une forme d'onde approchée avec un degré d'approximation d'une fonction radiofréquence RF en dent de scie normalisée en amplitude et en temps.

La fonction radiofréquence en dent de scie normalisée présente un motif périodique de période fondamentale consistant en une première portion linéaire d'évolution temporelle de la tension normalisée avec une première pente p1, suivie immédiatement d'une deuxième portion linéaire d'évolution temporelle de la tension normalisée avec une deuxième pente p2, les premiere et deuxième pentes étant d'amplitudes différentes et de signes opposés, le minimum et le maximum du motif ayant la même amplitude unitaire.

Le degré d'approximation de la forme d'onde approchée et la pression P du gaz sont suffisantes pour faire apparaitre une asymétrie des flux ioniques entre le flux ionique au niveau de la première électrode et le flux ionique au niveau de la deuxième électrode.

La plus petite valeur absolue parmi la valeur absolue de la première pente p1 et la valeur absolue de deuxième pente p2 est inférieure ou égale à une valeur égale à 3,8 de préférence inférieure ou égale 2,5, et encore plus de préférence inférieur ou égal 2.

Le degré d'approximation de la forme d'onde approchée est égal à l'inverse d'une distance fonctionnelle $\underline{d}$ séparant la forme d'onde de tension approchée normalisée et la fonction radiofréquence en dent de scie $f_{saw}(u)$ normalisée, la distance fonctionnelle étant comprise dans l'ensemble formé par les distances fonctionnelles $L^p$ de Lebesgue.

Par exemple, la distance fonctionnelle d1 et la distance fonctionnelle $d\infty$, séparant la forme d'onde approchée normalisée et la fonction radiofréquence en dent de scie normalisée, sont définies respetivement par les expression analytique :

$$d1(f(u); f_{SAW}(u)) = \int_0^1 |f(u) - f_{SAW}(u)|.du,$$

$$d\infty(f(u); f_{SAW}(u)) = \max_{u \in \{0,1\}}(|f(u) - f_{SAW}(u)|$$

dans laquelle u est la variable normalisée definie par $u = \omega t/2\pi$, f(u) est la représentation normalisée de la forme d'onde approchée, et $f_{SAW}(u)$ est la représentation normalisée de la fonction en dent de scie associée.

Lorsque la distance $d\infty$ est utilisé, $d\infty(f(u); f_{SAW}(u))$ est inférieure ou égale à 0,8, de préférence inférieure ou égale à 0,5, cette distance étant égale à 0,4 lorsque la forme d'onde approchée et la fonction en dent de scie associée sont respectivement la première forme d'onde 102 non optimisée après normalisation de la Figure 9 et la fonction en dent de scie 184 associée après normalisation de la Figure 9. De manière correspondante, le degré d'approximation est supérieur ou égal à 1,25, de préférence supérieur ou égal 2.

Lorsque la distance d1 est utilisée, $d1(f(u); f_{SAW}(u))$ est inférieure ou égale à 0,5, de préférence inférieure ou égale à 0,2.

La Figure 14 est un exemple permettant de visualiser une distance d1 fonctionnelle séparant la première forme d'onde 102 non optimisée après normalisation de la Figure 9 et la fonction en dent de scie 184 associée après normalisation de la Figure 9.

La distance fonctionnelle d1 séparant la première forme d'onde 102, non optimisée et normalisée, et la fonction en dent de scie 184 normalisée est définie par l'expression analytique :

$$d1(f(u); f_{SAW}(u)) = \int_0^1 |f(u) - f_{SAW}(u)|.du,$$

dans laquelle u est la variable normalisée definie par $u = \omega t/2\pi$, f(u) est la représentation normalisée de la première forme d'onde non optimsée, et $f_{SAW}(u)$ est la représentation normalisée de la fonction en dent de scie associée.

Dans ce cas, la somme des aires différentielles des zones 292, 294, 296, 298, hachurées de traits et contenues entre les courbes 102 et 184 lorsque u varie sur une longueur unitaire, représente la distance $d1(f(u); f_{SAW}(u))$.

Il peut observée qu'avec cette représentation géométrique, en se reportant à la figure 9, il apparait clairement que la première forme d'onde optimisée est plus proche de la fonction en dent de scie que ne l'est la première forme d'onde non optimisée.

Ainsi, des simulations de plasmas ont montré l'efficacité du procédé selon l'invention avec deux chimies différentes, l'une concernant un plasma d'argon, l'autre concernant un plasma d'hydrogène.

D'autre part, des expériences menés sur des dépôts de silicium par voie plasma en utilisant les deux formes de signaux ont prouvés quant à eux la faisabilité de ce procédé.

Les critères de bonnes performances d'un dépôt réalisés sur un substrat sont les suivants :

- Un dépôt rapide sur le substrat, c'est-à-dire un grand flux ionique ,
- Une faible énergie de bombardement des ions arrivant sur le substrat ;
- Une vitesse de dépôt faible sur l'électrode opposée à celle voisine du substrat pour réduire la fréquence de nettoyage et une meilleure utilisation des gaz.

Le procédé selon l'invention permet de répondre à ces critères à l'inverse des procédés de dépôt plasma classiques.

En effet, la haute fréquence utilisée seule permet certes d'augmenter la vitesse de dépôt aux niveaux respectifs des deux électrodes mais de la même façon sur les deux électrodes. L'asymétrie d'amplitude permet certes de diminuer l'énergie de bombardement ionique sur le substrat mais la vitesse de dépôt sera plus élevée sur l'autre électrode, opposée à l'électrode voisine du substrat.

Les mêmes avantages distinctifs sont obtenus pour des procédés de gravure ou de traitement de surface par plasma en remplaçant la vitesse de dépôt respectivement par la vitesse de gravure ou la vitesse de traitement de surface.

**Revendications**

1. Procédé de génération d'une asymétrie de flux ionique dans un réacteur plasma radiofréquence capacitivement couplé (4),
Le réacteur plasma (4) contenant un ou plusieurs gaz mélangés (6) sous une pression totale P, et comportant une première électrode (24), alimentée en énergie radiofréquence, et une deuxième électrode (26),
Le procédé comprenant une étape d'excitation de la première électrode (24) par une forme d'onde de tension radio-fréquence périodique V(t) ayant une fréquence inférieure correspondant à un harmonique fondamental de période fondamentale T de la forme d'onde ;
**caractérisé en ce que**
la forme d'onde de tension normalisée en temps et en amplitude sur l'intervalle [-1 ; 1], f(u) est une forme d'onde approchée avec un degré d'approximation d'une fonction radiofréquence en dent de scie normalisée $f_{SAW}(u)$, u étant le temps normalisé défini comme le rapport du temps t sur la période fondamentale T, et
la fonction radiofréquence en dent de scie normalisée présente un motif périodique de période fondamentale T consistant en une première portion linéaire d'évolution temporelle de la tension normalisée avec une première pente p1, suivie immédiatement d'une deuxième portion linéaire d'évolution temporelle de la tension normalisée avec une deuxième pente p2, les premiere et deuxième pentes étant d'amplitudes différentes et de signes opposés, le minimum et le maximum du motif ayant la même amplitude unitaire ; et
le degré d'approximation de la forme d'onde approchée et la pression totale P du gaz ou des gaz mélangés sont suffisamment élevés pour faire apparaitre une asymétrie des flux ioniques entre le flux ionique au niveau de la première électrode et le flux ionique au niveau de la deuxième électrode.

2. Procédé de génération d'une asymétrie de flux ionique selon la revendication 1, dans lequel la plus petite valeur absolue parmi la valeur absolue de la première pente p1 et la valeur absolue de deuxième pente p2 est inférieure ou égale à une valeur égale à 3,8 de préférence inférieure ou égale 3.

3. Procédé de génération d'une asymétrie de flux ionique selon l'une quelconque des revendications 1 à 2, dans lequel la forme d'onde de tension radio-fréquence périodique V(t) est dérivable et présente une asymétrie de pente mesurée par un facteur d'asymétrie de pente F paramétré par un entier p supérieur ou égal à 1 et défini par l'équation :

$$F(p) = \left| \frac{\left| \int_{t \in [0,T], V'>0} (V'(t))^p \right| - \left| \int_{t \in [0,T], V'<0} (V'(t))^p \right|}{\left| \int_{t \in [0,T]} (V'(t))^p \right|} \right|$$

V'(t) designant la dérivée de la forme d'onde à l'instant t, et
F(p) est supérieur ou égal à un seuil, lequel seuil dépend de l'entier p et est égal à 0,1 lorsque p est égal à 2.

4. Procédé de génération d'une asymétrie de flux ionique selon l'une quelconque des revendications 1 à 3, dans lequel la pression totale P du gaz ou des gaz mélangés est supérieure ou égale à une valeur seuil de pression $P_s$(gaz), dépendant de la nature du gaz et définie comme la pression au-dessus de laquelle une asymétrie du flux ionique apparait nettement entre le flux ionique au niveau de la première électrode (24) et le flux ionique au niveau de la deuxième électrode (26), lorsque la forme d'onde normalisée est une fonction en dent de scie normalisée pour laquelle la valeur absolue de la pente la plus douce est égale à 2,5 ou le facteur d'asymétrie de pente F(2) de la forme d'onde V(t) est supérieur ou égal 0,1.

5. Procédé de génération d'une asymétrie de flux ionique selon l'une quelconque des revendications 1 à 4, dans lequel le gaz est un gaz convenant pour le dépôt de matériaux sur, pour la gravure, et pour la modification d'un substrat compris dans l'ensemble formé par l'argon, le dihydrogène, $O_2$, $Cl_2$, HBr, $CF_4$, $C_4F_8$, $CHF_3$, CO, $SiH_4$, $SiCl_4$, $SiF_4$, $CH_4$, $C_2H_6$ et les chaines carbonées de même structures, $SF_6$, $Si_2H_6$, $SiH_xF_{4-x}$, $GeH_4$, $GeF_4$, $GeH_xF_{4-x}$, $CCl_4$, $CCl_3F$, $CCl_2F_2$, $CF_3Cl$, $C_2F_6$, $C_3F_8$, $C_5F_8$, $C_5F_{12}$, $CHF_3$, $BCl_3$ et la valeur du seuil de pression est égale à 100 mTorr lorsque le gaz est de l'argon.

**6.** Procédé de génération d'une asymétrie de flux ionique selon l'une des revendications 1 à 5, dans lequel le degré d'approximation de la forme d'onde approchée est égal à l'inverse d'une distance fonctionnelle d séparant la forme d'onde de tension approchée normalisée f(u) et la fonction radiofréquence en dent de scie normalisée $f_{saw}(u)$, la distance fonctionnelle étant comprise dans l'ensemble formé par les distances fonctionnelles $L^p$ de Lebesgue,

le degré d'approximation étant supérieur ou égal à 1,25, de préférence supérieur ou égal 2 lorsque la distance fonctionnelle d est la distance fonctionnelle $d\infty$, séparant la forme d'onde approchée normalisée et la fonction radiofréquence en dent de scie normalisée, définie par l'expression analytique :

$$d\infty(f(u); f_{SAW}(u)) = \max_{u \in [0,1]}(|f(u) - f_{SAW}(u)|)$$

dans laquelle u est la variable normalisée definie par $u = \omega t / 2\pi$.

**7.** Procédé de génération d'une asymétrie de flux ionique selon l'une des revendications 1 à 6, dans lequel la forme d'onde de tension approchée après normalisation f(u) est une forme d'onde non invariante par retournement temporel, c'est-à-dire une forme d'onde pour laquelle il n'existe pas de constante réelle $\tau$ vérifiant : $f(u) = f(\tau - u)$, u désignant la variable d'évolution temporelle normalisée de la forme d'onde de tension approchée normalisée.

**8.** Procédé de génération d'une asymétrie de flux ionique selon l'une quelconque des revendications 1 à 7, dans lequel pour chaque maximum courant de la forme d'onde de tension approchée normalisée identifié par un indice de parcours j, la durée séparant l'instant d'occurrence t(max(j)) du maximum courant de l'instant d'occurrence t(min(j)) du premier mimimum min(j) suivant le maximum courant max(j), est différente de la durée séparant l'instant d'occurence t(max(j+1)) du premier maximum max(j+1) succédant immédiament au premier mimimum min(j) et l'instant d'occurrence t(min(j)) du premier minimum min(j).

**9.** Procédé de génération d'une asymétrie de flux ionique selon l'une quelconque des revendications 1 à 8, dans lequel la forme d'onde approchée avant d'être normalisée est égale à un développement d'une série tronquée approximant une fonction en dent de scie limitée à un nombre entier n des premières fréquences harmoniques, et décrite par l'équation :

$$V_{AC}(t) = V_0 \sum_{k=1}^{n} \frac{2(-1)^k}{k^2 m(1-m)\pi^2} \sin(k(1-m)\pi) \sin(k\omega t),$$

$V_0$ étant un facteur de tension ajusté pour obtenir une tension crête souhaitée $V_{pp}$, le nombre des premieres fréquences harmoniques n du développement de la série est étant supérieur ou égal à 2, $\omega$ étant la pulsation correspondant à la fréquence fondamentale, et m étant un paramètre réel compris entre 0 et 1, les valeurs m appartenant à l'intervalle [0,5-$\delta$4 0,5+$\delta$4] étant exclues, $\delta$4 étant supérieur ou égal à 0,1, de préférence supérieur ou égal à 0,2.

**10.** Procédé de génération d'une asymétrie de flux ionique selon l'une quelconque des revendication 1 à 8, dans lequel la forme d'onde approchée avant d'être normalisée est égale à un développement d'une série tronquée approximant une fonction en dent de scie limitée à un nombre entier n des premières fréquences harmoniques, et décrite suivant l'équation :

$$V_{AC}(t) = V_0 \sum_{k=1}^{n} \frac{1}{k} \cos(k\omega t + \Phi),$$

$V_0$ étant un facteur de tension ajusté pour obtenir une tension crête souhaitée $V_{pp}$, le nombre des premieres fréquences harmoniques $\underline{n}$ développement de la série étant supérieur ou égal à 2, $\omega$ étant la pulsation correspondant à la fréquence fondamentale,

et $\Phi$ étant une phase de décalage commune aux harmoniques comprise dans la réunion des intervalles

$$\left[\frac{\pi}{2} - \delta 3, \frac{\pi}{2} + \delta 3\right] \text{ et } \left[\frac{3\pi}{2} - \delta 3, \frac{3\pi}{2} + \delta 3\right]$$ avec $\delta 3$ inférieur ou égal à $\pi/4$, de préférence inférieur ou égal à $\pi/6$, et encore plus de préférence inférieur ou égal à $\pi/8$.

11. Procédé de génération d'une asymétrie de flux ionique selon l'une quelconque des revendication 1 à 8, dans lequel la forme d'onde approchée avant d'être normalisée est égale à un développement d'une série tronquée approximant une fonction en dent de scie limitée à un nombre entier $\underline{n}$ des premières fréquences harmoniques, et décrite par l'équation :

$$V_{AC}(t) = V_0 \sum_{k=1}^{n} \frac{n - k + 1}{n} \cos(k\omega t + \Phi) \,,$$

$V_0$ étant un facteur de tension ajusté pour obtenir une tension crête souhaitée $V_{pp}$, le nombre des premieres fréquences harmoniques $\underline{n}$ développement de la série étant supérieur ou égal à 2, $\omega$ étant la pulsation correspondant à la fréquence fondamentale,

et $\Phi$ étant une phase de décalage commune aux harmoniques comprise dans la réunion des intervalles

$$\left[\frac{\pi}{2} - \delta 2, \frac{\pi}{2} + \delta 2\right] \text{ et } \left[\frac{3\pi}{2} - \delta 2, \frac{3\pi}{2} + \delta 2\right]$$ avec $\delta 2$ inférieur ou égal à $\pi/4$, de préférence inférieur ou égal à $\pi/6$, et encore plus de préférence inférieur ou égal à $\pi/8$.

12. Procédé de génération d'une asymétrie de flux ionique selon l'une quelconque des revendication 1 à 11, dans lequel la forme d'onde approchée avant normalisation égale à un développement d'une série tronquée approximant la fonction en dent de scie limitée à un nombre entier $\underline{n}$ des premières fréquences harmoniques, le nombre d'harmoniques étant supérieur ou égal 3, de préférence égal à 4.

13. Procédé de génération d'une asymétrie de flux ionique selon l'une quelconque des revendication 1 à 12, dans lequel les première ét deuxième pentes p1, p2 et/ou le paramètre $\underline{m}$ sont ajustés par une boucle de rétroaction servant à obtenir la forme d'onde de tensions souhaitée à la première électrode (24) alimentée en énergie.

14. Procédé de traitement plasma d'un substrat dans un réacteur plasma capacitivement couplé,
Le réacteur plasma contenant un gaz sous une pression P, et comportant une première électrode (24), alimentée en énergie radiofréquence, et une deuxième électrode (26), comprenant
une étape de mise en place d'un substrat à traiter à proximité d'une électrode parmi la première électrode et la deuxièm électrode ; et
une étape de génération d'une asymétrie de flux ionique définie selon l'une des revendications 1 à 13.

15. Procédé de traitement plasma d'un substrat selon la revendication 14, dans lequel le gaz (6) utilisé permet de créer plusieurs espèces chimiques qui sont soit très réactives, soit peu réactives, et
la forme d'onde de la tension d'excitation est ajustée de sorte
soit à rapprocher la création des espèces réactives à proximité d'une électrode lorsqu'elles sont bénéfiques au traitement du substrat, ou
à éloigner les espèces sont peu réactives et agissent de manière néfaste au traitement du substrat.

16. Procédé de traitement plasma d'un substrat selon l'une quelconque des revendications 13 à 15, compris dans l'ensemble formé par les procédés plasma de dépôt sur un substrat, les procédés plasma de gravure d'un substrat, et les procédés plasma de modification de la surface d'un substrat.

17. Système de traitement plasma pour créer une asymétrie du flux ionique comprenant

- un réacteur plasma radiofréquence capacitivement couplé (4), contenant un gaz (6) ou des gaz mélangés sous une pression totale P, comportant une première électrode (24), alimentée en énergie radiofréquence, et une deuxième électrode (26), et

- un moyen (16) de réglage de la pression totale P du gaz ou des gaz mélangés ; et

- un générateur de forme d'onde de tension (32), raccordé à la première électrode (24) au travers d'une capacité de couplage (36), pour générer une forme d'onde de tension radio-fréquence périodique V(t) ayant une fréquence inférieure correspondant à un harmonique fondamental de la forme d'onde de période fondamentale T ;

**caractérisé en ce que**

la forme d'onde de tension normalisée la forme d'onde de tension normalisée en temps et en amplitude sur l'intervalle [-1 ; 1], f(u) est une forme d'onde approchée avec un degré d'approximation d'une fonction radiofréquence en dent de scie normalisée $f_{SAW}(u)$, u étant le temps normalisé défini comme le rapport du temps t sur la période fondamentale T, et

la fonction radiofréquence en dent de scie normalisée $f_{SAW}(u)$ présente un motif périodique de période fondamentale T consistant en une première portion linéaire d'évolution temporelle de la tension normalisée avec une première pente p1, suivie immédiatement d'une deuxième portion linéaire d'évolution temporelle de la tension normalisée avec une deuxième pente p2, les premiere et deuxième pentes étant d'amplitudes différentes et de signes opposés, le minimum et le maximum du motif ayant la même amplitude unitaire ; et

le degré d'approximation de la forme d'onde approchée et la pression totale P du gaz ou des gaz mélangés sont suffisantes pour faire apparaitre une asymétrie des flux ioniques entre le flux ionique au niveau de la première électrode et le flux ionique au niveau de la deuxième électrode.

18. Système de traitement plasma pour créer une asymétrie du flux ionique selon la revendication 17, dans lequel le moyen (16) de réglage de la pression totale P du gaz ou des gaz mélangés et le générateur de forme d'onde de tension (32) sont configurés pour mettre en oeuvre l'une des étapes définies selon l'une des revendications 2 à 13.

19. Système de traitement plasma pour créer une asymétrie du flux ionique selon l'une quelconque des revendications 17 à 18, dans lequel la deuxième électrode est mise à la masse ou à un potentiel flottant.

**Patentansprüche**

1. Verfahren zum Erzeugen einer Ionenflussasymmetrie in einem kapazitiv gekoppelten Radiofrequenz-Plasmareaktor (4),

wobei der Plasmareaktor (4) ein Gas oder mehrere Gasgemische (6) unter einem Gesamtdruck P enthält und eine erste Elektrode (24), die mit Radiofrequenzenergie versorgt wird, und eine zweite Elektrode (26) aufweist,

wobei das Verfahren einen Schritt des Anregens der ersten Elektrode (24) durch eine periodische Radiofrequenz-Spannungswellenform V(t) umfasst, die eine untere Frequenz aufweist, die einer Grundschwingung mit der Grundperiode T der Wellenform entspricht;

**dadurch gekennzeichnet, dass**

die in Zeit und Amplitude über das Intervall [-1; 1] normierte Spannungswellenform f(u) eine approximierte Wellenform mit einem Approximationsgrad einer normierten sägezahnförmigen Radiofrequenzfunktion $f_{SAW}(u)$ ist, wobei u die normierte Zeit ist, die als das Verhältnis der Zeit t zur Grundperiode T definiert ist, und

die normierte sägezahnförmige Radiofrequenzfunktion ein periodisches Muster der Grundperiode T aufweist, das aus einem ersten linearen Abschnitt der zeitlichen Entwicklung der normierten Spannung mit einer ersten Steigung p1 besteht, unmittelbar gefolgt von einem zweiten linearen Abschnitt der zeitlichen Entwicklung der normierten Spannung mit einer zweiten Steigung p2, wobei die erste und die zweite Steigung unterschiedliche Amplituden und entgegengesetzte Vorzeichen aufweisen, wobei das Minimum und das Maximum des Musters die gleiche Einheitsamplitude haben; und

der Approximationsgrad der approximierten Wellenform und der Gesamtdruck P des Gases oder der Gasgemische hoch genug sind, um eine Asymmetrie der Ionenflüsse zwischen dem Ionenfluss an der ersten Elektrode und dem Ionenfluss an der zweiten Elektrode zu bewirken.

2. Verfahren zum Erzeugen einer Ionenflussasymmetrie nach Anspruch 1, wobei der kleinste Absolutwert unter dem Absolutwert der ersten Steigung p1 und dem Absolutwert der zweiten Steigung p2 kleiner oder gleich einem Wert von 3,8, vorzugsweise kleiner oder gleich 3, ist.

3. Verfahren zum Erzeugen einer Ionenflussasymmetrie nach einem der Ansprüche 1 bis 2, wobei

die periodische Radiofrequenz-Spannungswellenform V(t) ableitbar ist und eine Steigungsasymmetrie aufweist, die durch einen Steigungsasymmetriefaktor F gemessen wird, der durch eine ganze Zahl p parametriert ist, die größer oder gleich 1 ist, und durch die folgende Gleichung definiert ist:

$$F(p) = \left| \frac{\int\limits_{t \in [0,T], V' > 0} \left| (V'(t))^p \right| - \int\limits_{t \in [0,T], V' < 0} \left| (V'(t))^p \right|}{\int\limits_{t \in [0,T]} \left| (V'(t))^p \right|} \right|$$

wobei V'(t) die Ableitung der Wellenform zum Zeitpunkt t bezeichnet und

F(p) größer oder gleich einem Schwellenwert ist, welcher von der ganzen Zahl p abhängt und gleich 0,1 ist, wenn p gleich 2 ist.

4.   Verfahren zum Erzeugen einer Ionenflussasymmetrie nach einem der Ansprüche 1 bis 3, wobei der Gesamtdruck P des Gases oder der Gasgemische größer oder gleich einem Druckschwellenwert $P_s$(Gas) ist, der von der Art des Gases abhängt und definiert ist als der Druck, oberhalb dessen eine Ionenflussasymmetrie zwischen dem Ionenfluss an der ersten Elektrode (24) und dem Ionenfluss an der zweiten Elektrode (26) deutlich auftritt, wenn die normierte Wellenform eine normierte sägezahnförmige Funktion ist, bei der der Absolutwert der flachsten Steigung gleich 2,5 ist oder der Steigungsasymmetriefaktor F(2) der Wellenform V(t) größer oder gleich 0,1 ist.

5.   Verfahren zum Erzeugen einer Ionenflussasymmetrie nach einem der Ansprüche 1 bis 4, wobei das Gas ein Gas ist, das geeignet ist zum Abscheiden von Stoffen auf einem Substrat, zum Ätzen und zum Modifizieren eines Substrats aus der Gruppe bestehend aus Argon, Wasserstoff, $O_2$, $Cl_2$, HBr, $CF_4$, $C_4F_8$, $CHF_3$, CO, $SiH_4$, $SiCl_4$, $SiF_4$, $CH_4$, $C_2H_6$ und Kohlenstoffketten der gleichen Struktur, $SF_6$, $Si_2H_6$, $SiH_xF_{4-x}$, $GeH_4$, $GeF_4$, $GeH_xF_{4-x}$, $CCl_4$, $CCl_3F$, $CCl_2F_2$, $CF_3Cl$, $C_2F_6$, $C_3F_8$, $C_5F_8$, $C_5F_{12}$, $CHF_3$, $BCl_3$ und der Druckschwellenwert gleich 100 mTorr ist, wenn das Gas Argon ist.

6.   Verfahren zum Erzeugen einer Ionenflussasymmetrie nach einem der Ansprüche 1 bis 5, wobei
der Approximationsgrad der approximierten Wellenform gleich dem Kehrwert einer funktionellen Distanz d ist, die die normierte approximierte Spannungswellenform f(u) und die normierten sägezahnförmige Radiofrequenzfunktion $f_{saw}$(u) trennt, wobei die funktionelle Distanz in der Menge enthalten ist, die durch die funktionellen Lebesgue-Distanzen $L^p$ gebildet wird,
der Approximationsgrad größer oder gleich 1,25, vorzugsweise größer oder gleich 2 ist, wenn die funktionelle Distanz d die funktionelle Distanz $d\infty$ ist, welche die normierte approximierte Wellenform und die normierte sägezahnförmige Radiofrequenzfunktion trennt, definiert durch den analytischen Ausdruck:

$$d\infty(f(u); f_{SAW}(u)) = \max_{u \in [0,1]} \left( \left| f(u) - f_{SAW}(u) \right| \right)$$

wobei u die normierte Variable ist, definiert durch $u = \omega t / 2\pi$.

7.   Verfahren zum Erzeugen einer Ionenflussasymmetrie nach einem der Ansprüche 1 bis 6, wobei die approximierte Spannungswellenform nach Normierung f(u) eine durch Zeitumkehr nicht-invariante Wellenform ist, das heißt eine Wellenform, für die es keine reelle Konstante $\tau$ gibt, die:
$f(u) = f(\tau - u)$ bestätigt, wobei u die normierte Zeitentwicklungsvariable der normierten approximierten Spannungswellenform bezeichnet.

8.   Verfahren zum Erzeugen einer Ionenflussasymmetrie nach einem der Ansprüche 1 bis 7, wobei für jedes aktuelle Maximum der normierten, approximierten Spannungswellenform, das durch einen Pfadindex j gekennzeichnet ist, die Dauer, die den Zeitpunkt des Auftretens t(max(j)) des aktuellen Maximums von dem Zeitpunkt des Auftretens t(min(j)) des ersten Minimums min(j) im Anschluss an das aktuelle Maximum max(j) trennt, verschieden ist von der Dauer, die den Zeitpunkt des Auftretens t(max(j+1)) des ersten Maximums max(j+1), das dem ersten Minimum min(j) unmittelbar folgt, und den Zeitpunkt des Auftretens t(min(j)) des ersten Minimums min(j) trennt.

**9.** Verfahren zum Erzeugen einer Ionenflussasymmetrie nach einem der Ansprüche 1 bis 8, wobei die approximierte Wellenform vor der Normierung gleich einer Entwicklung einer gekürzten Reihe ist, die eine sägezahnförmige Funktion approximiert, welche auf eine ganze Zahl n der ersten harmonischen Frequenzen begrenzt ist und beschrieben wird durch die Gleichung

$$V_{AC}(t) = V_0 \sum_{k=1}^{n} \frac{2(-1)^k}{k^2 m(1-m)\pi^2} \sin(k(1-m)\pi)\sin(k\omega t),$$

wobei $V_0$ ein Spannungsfaktor ist, der so angepasst ist, dass eine gewünschte Spitzenspannung $V_{pp}$ erhalten wird, wobei die Anzahl der ersten harmonischen Frequenzen n der Reihenentwicklung größer oder gleich 2 ist, wobei $\omega$ der der Grundfrequenz entsprechende Impuls ist und wobei m ein reeller Parameter zwischen 0 und 1 ist, wobei die Werte m, die zum Intervall [0,5-$\delta$4 0,5+$\delta$4} gehören, ausgeschlossen sind, wobei $\delta$4 größer oder gleich 0,1, vorzugsweise größer oder gleich 0,2 ist.

**10.** Verfahren zum Erzeugen einer Ionenflussasymmetrie nach einem der Ansprüche 1 bis 8, wobei die approximierte Wellenform vor der Normierung gleich einer Entwicklung einer gekürzten Reihe ist, die eine sägezahnförmige Funktion approximiert, welche auf eine ganze Zahl n der ersten harmonischen Frequenzen begrenzt ist und beschrieben wird durch die Gleichung:

$$V_{AC}(t) = V_0 \sum_{k=1}^{n} \frac{1}{k} \cos(k\omega t + \Phi),$$

wobei $V_0$ ein Spannungsfaktor ist, der so angepasst ist, dass eine gewünschte Spitzenspannung $V_{pp}$ erhalten wird, wobei die Anzahl der ersten harmonischen Frequenzen n der Reihenentwicklung größer oder gleich 2 ist, wobei $\omega$ der der Grundfrequenz entsprechende Impuls ist, und wobei $\Phi$ eine den harmonischen Schwingungen gemeine Versatzsphase innerhalb der Vereinigung der Intervalle

$$\left[\frac{\pi}{2} - \delta 3, \frac{\pi}{2} + \delta 3\right] \quad \text{und} \quad \left[\frac{3\pi}{2} - \delta 3, \frac{3\pi}{2} + \delta 3\right]$$

ist, mit $\delta$3 kleiner oder gleich $\pi$/4, vorzugsweise kleiner oder gleich $\pi$/6, und besonders vorzugsweise kleiner oder gleich $\pi$/8.

**11.** Verfahren zum Erzeugen einer Ionenflussasymmetrie nach einem der Ansprüche 1 bis 8, wobei die approximierte Wellenform vor der Normierung gleich einer Entwicklung einer gekürzten Reihe ist, die eine sägezahnförmige Funktion approximiert, welche auf eine ganze Zahl n der ersten harmonischen Frequenzen begrenzt ist und beschrieben wird durch die Gleichung:

$$V_{AC}(t) = V_0 \sum_{k=1}^{n} \frac{n-k+1}{n} \cos(k\omega t + \Phi),$$

wobei $V_0$ ein Spannungsfaktor ist, der so angepasst ist, dass eine gewünschte Spitzenspannung $V_{pp}$ erhalten wird, wobei die Anzahl der ersten harmonischen Frequenzen n der Reihenentwicklung größer oder gleich 2 ist, wobei $\omega$ der der Grundfrequenz entsprechende Impuls ist, und wobei $\Phi$ eine den harmonischen Schwingungen gemeine Versatzsphase innerhalb der Vereinigung der Intervalle

EP 3 138 116 B1

$$\left[\frac{\pi}{2}-\delta2, \frac{\pi}{2}+\delta2\right] \qquad \left[\frac{3\pi}{2}-\delta2, \frac{3\pi}{2}+\delta2\right]$$

und ist, mit $\delta2$ kleiner oder gleich $\pi/4$, vorzugsweise kleiner oder gleich $\pi/6$, und besonders vorzugsweise kleiner oder gleich $\pi/8$.

12. Verfahren zum Erzeugen einer Ionenflussasymmetrie nach einem der Ansprüche 1 bis 11, wobei die approximierte Wellenform vor Normierung gleich einer Entwicklung einer gekürzten Reihe ist, die eine sägezahnförmige Funktion approximiert, welche auf eine ganze Zahl n der ersten harmonischen Frequenzen begrenzt ist, wobei die Anzahl der harmonischen Schwingungen größer oder gleich 3, vorzugsweise gleich 4 ist.

13. Verfahren zum Erzeugen einer Ionenflussasymmetrie nach einem der Ansprüche 1 bis 12, wobei die erste und zweite Steigung p1, p2 und/oder der Parameter m durch eine Rückkopplungsschleife abgestimmt werden, um die gewünschte Spannungswellenform an der ersten, mit Energie versorgten Elektrode (24) zu erhalten.

14. Verfahren zur Plasmabehandlung eines Substrats in einem kapazitiv gekoppelten Plasmareaktor, wobei der Plasmareaktor ein Gas unter einem Druck P enthält und eine erste Elektrode (24), die mit Radiofrequenzenergie versorgt wird, und eine zweite Elektrode (26) aufweist, mit

einem Schritt, wobei ein zu behandelndes Substrat in der Nähe einer der beiden Elektroden, der ersten Elektrode und der zweiten Elektrode, positioniert wird; und
einem Schritt zum Erzeugen einer nach einem der Ansprüche 1 bis 13 definierten Ionenflussasymmetrie.

15. Verfahren zur Plasmabehandlung eines Substrats nach Anspruch 14, wobei das verwendete Gas (6) eine Vielzahl von chemischen Spezies erzeugen kann, die entweder hochreaktiv oder wenig reaktiv sind, und die Wellenform der Anregungsspannung so abgestimmt ist,
dass entweder die Erzeugung der reaktiven Spezies näher an eine Elektrode angenähert wird, wenn die Spezies für die Substratbehandlung vorteilhaft sind, oder
die Spezies weiter entfernt werden, wenn diese wenig reaktiv sind oder sich nachteilig auf die Substratbehandlung auswirken.

16. Verfahren zur Plasmabehandlung eines Substrats nach einem der Ansprüche 13 bis 15, enthalten in der Gruppe bestehend aus Plasmaverfahren zum Abscheiden auf einem Substrat, Plasmaverfahren zum Ätzen eines Substrats und Plasmaverfahren zum Modifizieren der Oberfläche eines Substrats.

17. Plasmabehandlungssystem zum Erzeugen einer Ionenflussasymmetrie mit

- einem kapazitiv gekoppelten Radiofrequenz-Plasmareaktor (4), der ein Gas (6) oder mehrere Gasgemische unter einem Gesamtdruck P enthält und eine erste Elektrode (24), die mit Radiofrequenzenergie versorgt wird, und eine zweite Elektrode (26) aufweist, und
- einem Mittel (16) zur Einstellung des Gesamtdrucks P des Gases oder der Gasgemische; und
- einem Spannungswellenformgenerator (32), der über eine Kopplungskapazität (36) mit der ersten Elektrode (24) verbunden ist, um eine periodische Radiofrequenz-Spannungswellenform V(t) zu erzeugen, die eine untere Frequenz aufweist, die einer Grundschwingung der Wellenform mit der Grundperiode T entspricht;

**dadurch gekennzeichnet, dass**
die normierte Spannungswellenform, die in Zeit und Amplitude über das Intervall [-1; 1] normierte Spannungswellenform, f(u) eine approximierte Wellenform mit einem Approximationsgrad einer normierten sägezahnförmigen Radiofrequenzfunktion $f_{SAW}(u)$ ist, wobei u die normierte Zeit ist, die als das Verhältnis der Zeit t zur Grundperiode T definiert ist, und
die normierte sägezahnförmige Radiofrequenzfunktion $f_{SAW}(u)$ ein periodisches Muster der Grundperiode T aufweist, das aus einem ersten linearen Abschnitt der zeitlichen Entwicklung der normierten Spannung mit einer ersten Steigung p1 besteht, unmittelbar gefolgt von einem zweiten linearen Abschnitt der zeitlichen Entwicklung der normierten Spannung mit einer zweiten Steigung p2, wobei die erste und die zweite Steigung unterschiedliche Amplituden und entgegengesetzte Vorzeichen aufweisen, wobei das Minimum und das Maximum des Musters die gleiche Einheitsamplitude haben; und
der Approximationsgrad der approximierten Wellenform und der Gesamtdruck P des Gases oder der Gasgemische ausreichend sind, um eine Asymmetrie der Ionenflüsse zwischen dem Ionenfluss an der ersten Elektrode und dem Ionenfluss an der zweiten Elektrode zu bewirken.

18. Plasmabehandlungssystem zum Erzeugen einer Ionenflussasymmetrie nach Anspruch 17, wobei das Mittel (16) zur Einstellung des Gesamtdrucks P des Gases oder der Gasgemische und der Spannungswellenformgenerator (32) so konfiguriert sind, dass sie einen der nach einem der Ansprüche 2 bis 13 definierten Schritte ausführen.

19. Plasmabehandlungssystem zum Erzeugen einer Ionenflussasymmetrie nach einem der Ansprüche 17 bis 18, wobei die zweite Elektrode geerdet ist oder auf einem schwebenden Potential liegt.

**Claims**

1. A method for generating an ion flow asymmetry in a capacitively coupled radiofrequency plasma reactor (4), the plasma reactor (4) containing one or several mixed gases (6) under a total pressure P, and including a first electrode (24), supplied with radiofrequency energy, and a second electrode (26), the method comprising a step for energizing the first electrode (24) with a periodic radiofrequency voltage waveform V(t) having a lower frequency corresponding to a fundamental harmonic of a fundamental period T of the waveform; **characterized in that** the voltage waveform standardized in time and in amplitude over the interval [-1; 1], f(u) is an approximate waveform with a degree of approximation of a standardized sawtooth radiofrequency function $f_{SAW}(u)$, u being the standardized time defined as the ratio of the time t over the fundamental period T, and the standardized sawtooth radiofrequency function has a periodic pattern of fundamental period T consisting in a first linear portion of the time development of the standardized voltage with a first slope p1, immediately followed by a second linear portion of time development of the standardized voltage with a second slope p2, the first and second slopes being of different amplitudes and of opposite signs, the minimum and the maximum of the pattern having the same unit amplitude; and the degree of approximation of the approximate waveform and the total pressure P of the gas or the mixed gases are sufficiently high so as to cause appearance of an asymmetry of the ion flows between the ion flow at the first electrode and the ion flow at the second electrode.

2. The method for generating ion flow asymmetry according to claim 1, wherein the smallest absolute value from among the absolute value of the first slope p1 and the absolute value of the second slope p2 is less than or equal to a value equal to 3.8 preferably less than or equal to 3.

3. The method for generating an ion flow asymmetry according to any of claims 1 to 2, wherein the periodic radiofrequency voltage waveform V(t) is differentiable and has a slope asymmetry measured by a slope asymmetry factor F parameterized by an integer p greater than or equal to 1 and defined by the equation:

$$F(p) = \left| \frac{\left| \int_{t \in [0,T], V' > 0} \left|(V'(t))^p\right| - \int_{t \in [0,T], V' < 0} \left|(V'(t))^p\right| \right|}{\int_{t \in [0,T]} \left|(V't))^p\right|} \right|$$

V'(t) designating the derivative of the waveform at instant t, and F(p) is greater than or equal to a threshold, which threshold depends on the integer p and is equal to 0.1 when p is equal to 2.

4. The method for generating an ion flow asymmetry according to any of claims 1 to 3, wherein the total pressure P of the gas or of the mixed gases is greater than or equal to a threshold pressure value $P_s(gas)$, depending on the nature of the gas and defined as the pressure above which an asymmetry of the ion flow clearly appears between the ion flow at the first electrode (24) and the ion flow at the second electrode (26), when the standardized waveform is a standardized sawtooth function for which the absolute value of the gentlest slope is equal to 2.5 or the slope asymmetry factor F(2) of the waveform V(t) is greater than or equal to 0.1.

5. The method for generating an ion flow asymmetry according to any of claims 1 to 4, wherein the gas is a gas suitable for depositing materials on, for etching, and for modifying a substrate comprised in the set formed with argon,

dihydrogen, $O_2$, $Cl_2$, HBr, $CF_4$, $C_4F_8$, $CHF_3$, CO, $SiH_4$, $SiCl_4$, $SiF_4$, $CH_4$, $C_2H_6$ and the carbonaceous chains of same structures, $SF_6$, $Si_2H_6$, $SiH_xF_{4-x}$, $GeH_4$, $GeF_4$, $GeH_xF_{4-x}$, $CCl_4$, $CCl_3F$, $CCl_2F_2$, $CF_3Cl$, $C_2F_6$, $C_3F_8$, $C_5F_8$, $C_5F_{12}$, $CHF_3$, $BCl_3$ and the value of the pressure threshold is equal to 100 mTorrs when the gas is argon.

6. The method for generating ion flow asymmetry according to one of claims 1 to 5, wherein the degree of approximation of the approximate waveform is equal to the reciprocal of a functional distance d separating the standardized approximate voltage waveform f(u) and the standardized sawtooth radiofrequency function $f_{saw}(u)$, the functional distance being comprised in the set formed by the functional distances $L^p$ of Lebesgue, the degree of approximation being greater than or equal to 1.25, preferably greater than or equal to 2 when the functional distance d is the functional distance $d\infty$, separating the standardized approximate waveform and the standardized sawtooth radiofrequency function, defined by the analytical expression:

$$d\infty(f(u); f_{SAW}(u)) = \max_{u \in [0,1]} \left( \left| f(u) - f_{SAW}(u) \right| \right)$$

wherein u is the standardized variable defined by $u = \omega t / 2\pi$.

7. The method for generating an ion flow asymmetry according to one of claims 1 to 6, wherein the approximate voltage waveform after standardization f(u) is a non-invariant waveform by time reversal, i.e. a waveform for which no real constant $\tau$ exists which satisfies:
$f(u) = f(\tau - u)$, u designating the standardized time development variable of the standardized approximate voltage waveform.

8. The method for generating an ion flow asymmetry according to any of claims 1 to 7, wherein for each current maximum of the standardized approximate voltage waveform identified by a travel index j, the duration separating the instant of occurrence t(max(j)) of the current maximum of the instant of occurrence t(min(j)) of the first minimum min(j) according to the current maximum max(j), is different from the duration separating the instant of occurrence t(max(j+1)) of the first maximum max(j+1) immediately following the first minimum min(j) and the instant of occurrence t(min(j)) of the first minimum min(j).

9. The method for generating an ion flow asymmetry according to any of claims 1 to 8, wherein the approximate waveform before being standardized is equal to a development of a truncated series approximating a sawtooth function limited to an integer number n of the first harmonic frequencies, and described by the equation:

$$V_{AC}(t) = V_0 \sum_{k=1}^{n} \frac{2(-1)^k}{k^2 m(1-m)\pi^2} \sin(k(1-m)\pi) \sin(k\omega t),$$

$V_0$ being an adjusted voltage factor for obtaining a desired peak voltage $V_{pp}$, the number of the first harmonic frequencies n of the development of the series is greater than or equal to 2, $\omega$ being the angular frequency corresponding to the fundamental frequency, and m being a real parameter comprised between 0 and 1, the values m belonging to the interval [0.5-$\delta$4 0.5+$\delta$4] being excluded, $\delta$4 being greater than or equal to 0.1, preferably greater than or equal to 0.2.

10. The method for generating an ion flow asymmetry according to any of claims 1 to 8, wherein the approximate waveform before being standardized is equal to a development of a truncated series approximating a sawtooth function limited to an integer number n of the first harmonic frequencies, and described according to the equation:

$$V_{AC}(t) = V_0 \sum_{k=1}^{n} \frac{1}{k} \cos(k\omega t + \Phi),$$

$V_0$ being an adjusted voltage factor for obtaining a desired peak voltage $V_{pp}$, the number of the first harmonic frequencies n of the development of the series being greater than or equal to 2, $\omega$ being the angular frequency corresponding to the fundamental frequency,

and Φ being a phase shift common to the harmonics comprised in the union of the intervals $\left[\dfrac{\pi}{2} - \delta3, \dfrac{\pi}{2} + \delta3\right]$

and $\left[\dfrac{3\pi}{2} - \delta3, \dfrac{3\pi}{2} + \delta3\right]$ with $\delta3$ less than or equal to $\pi/4$, preferably less than or equal to $\pi/6$, and even more preferably less than or equal to $\pi/8$.

11. The method for generating an ion flow asymmetry according to any of claims 1 to 8, wherein the approximate waveform before being standardized is equal to a development of a truncated series approximating a sawtooth function limited to an integer number $\underline{n}$ of the first harmonic frequencies, and described by the equation:

$$V_{AC}(t) = V_0 \sum_{k=1}^{n} \frac{n-k+1}{n} \cos(k\omega t + \Phi) \, ,$$

$V_0$ being an adjusted voltage factor for obtaining a desired peak voltage $V_{pp}$, the number of the first harmonic frequencies $\underline{n}$ of the development of the series being greater than or equal to 2, ω being the angular frequency corresponding to the fundamental frequency,

and Φ being a phase shift common to the harmonics comprised in the union of the intervals $\left[\dfrac{\pi}{2} - \delta2, \dfrac{\pi}{2} + \delta2\right]$

and $\left[\dfrac{3\pi}{2} - \delta2, \dfrac{3\pi}{2} + \delta2\right]$ with $\delta2$ less than or equal to $\pi/4$, preferably less than or equal to $\pi/6$, and even more preferably less than or equal to $\pi/8$.

12. The method for generating an ion flow asymmetry according to any of claims 1 to 11, wherein the approximate waveform before standardization is equal to a development of a truncated series approximating the sawtooth function limited to an integer number $\underline{n}$ of the first harmonic frequencies, the number of harmonics being greater than or equal to 3, preferably equal to 4.

13. The method for generating an ion flow asymmetry according to any of claims 1 to 12, wherein the first and second slopes p1, p2 and/or the parameter $\underline{m}$ are adjusted by a feedback loop used for obtaining the desired voltage waveform at the first electrode (24) supplied with energy.

14. A plasma treatment method for a substrate in a capacitively coupled plasma reactor,
the plasma reactor containing a gas under pressure P, and including a first electrode (24), supplied with radiofrequency energy, and a second electrode (26), comprising
a step for setting into place a substrate to be treated in proximity to an electrode from among the first electrode and the second electrode; and
a step for generating an ion flow asymmetry defined according to one of claims 1 to 13.

15. The plasma treatment method for a substrate according to claim 14, wherein the gas (6) used gives the possibility of generating several chemical species which are either highly reactive, or not very reactive, and
the waveform of the energization voltage is adjusted so as
either to move the generation of the reactive species closer to an electrode when they are beneficial to the treatment of the substrate, or
to move away the species which are not very reactive and which act detrimentally to the treatment of the substrate.

16. The plasma treatment method for a substrate according to any of claims 13 to 15, comprised in the set formed by plasma methods for deposition on a substrate, the plasma methods for etching a substrate, and the plasma methods for modifying the surface of a substrate.

**17.** The plasma treatment system for generating an ion flow asymmetry comprising

- a capacitively coupled radiofrequency plasma reactor (4), containing a gas (6) or mixed gases under a total pressure P, including a first electrode (24), supplied with radiofrequency energy and a second electrode (26), and
- a means (16) for adjusting the total pressure P of the gas or of the mixed gases; and
- a voltage waveform generator (32), connected to the first electrode (24) through a coupling capacitor (36), for generating a periodic radiofrequency voltage waveform V(t) having a lower frequency corresponding to a fundamental harmonic of the waveform of fundamental period T;

**characterized in that**
the standardized voltage waveform in time and in amplitude on the interval [-1; 1], f(u) is the approximate waveform with a degree of approximation of a standardized sawtooth radiofrequency function $f_{SAW}(u)$, u being the standardized time defined as the ratio of the time t over the fundamental period T, and

the standardized sawtooth radiofrequency function $f_{SAW}(u)$ has a periodic pattern of fundamental period T consisting in a first linear portion of time-dependent change in the standardized voltage with a first slope p1, immediately followed by a second linear portion of time-dependent change of the standardized voltage with a second slope p2, the first and second slopes being of different amplitudes and of opposite signs, the minimum and the maximum of the pattern having the same unit amplitude; and

the degree of approximation of the approximate waveform and the total pressure P of the gas or of the mixed gases are sufficient for causing appearance of an asymmetry of the ion flows between the ion flow at the first electrode and the ion flow at the second electrode.

**18.** The plasma treatment system for generating an asymmetry of the ion flow according to claim 17, wherein the means (16) for adjusting the total pressure P of the gas or of the mixed gases and the voltage waveform generator (32) are configured for applying one of the steps defined according to one of claims 2 to 13.

**19.** The plasma treatment system for generating an asymmetry of the ion flow according to any of claims 17 to 18, wherein the second electrode is grounded or at a floating potential.

Fig. 1

Fig. 2

*Fig. 3*

*Fig. 4*

*Fig. 5*

*Fig. 6*

Fig. 7a

Fig. 7b

Fig. 8

Fig. 9

*Fig. 10*

*Fig. 11*

*Fig. 12*

*Fig. 13*

Fig. 14

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2249372 A1
- EP 2407998 A1

- US 6162709 A

**Littérature non-brevet citée dans la description**

- **B.G. HEIL ; U. CZANETZKI ; R.P. BRINKMANN ; T. MUSSENBROCK.** On the possibility of making a geometrically symmetric RF-CCP discharge electrically asymmetric. *Journal of Physics D : Applied Physics,* Août 2008, vol. 41 (16), 165202